(19) Europäisches Patentamt
European Patent Office
Office européen des brevets

(11) **EP 4 585 933 A1**

(12) **EUROPEAN PATENT APPLICATION**
published in accordance with Art. 153(4) EPC

(43) Date of publication:
**16.07.2025 Bulletin 2025/29**

(21) Application number: **23862967.9**

(22) Date of filing: **25.08.2023**

(51) International Patent Classification (IPC):
**G01R 27/02** *(2006.01)*   **G01K 7/02** *(2021.01)*
**G01N 27/04** *(2006.01)*

(52) Cooperative Patent Classification (CPC):
**G01K 7/02; G01N 27/04; G01R 27/02**

(86) International application number:
**PCT/JP2023/030718**

(87) International publication number:
**WO 2024/053428 (14.03.2024 Gazette 2024/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **09.09.2022 JP 2022144045
19.06.2023 JP 2023100106**

(71) Applicant: **Hioki E.E. Corporation
Ueda-shi, Nagano 386-1192 (JP)**

(72) Inventors:
• **NAGAI, Hideyuki
Ueda-shi, Nagano 386-1192 (JP)**
• **MATSUBAYASHI, Hideo
Ueda-shi, Nagano 386-1192 (JP)**
• **NISHIZAWA, Takafumi
Ueda-shi, Nagano 386-1192 (JP)**
• **KIMOTO, Motoaki
Ueda-shi, Nagano 386-1192 (JP)**

(74) Representative: **Reddie & Grose LLP
The White Chapel Building
10 Whitechapel High Street
London E1 8QS (GB)**

(54) **RESISTANCE MEASUREMENT DEVICE AND RESISTANCE MEASUREMENT METHOD**

(57)    A resistance measurement device includes a connection structure including a set of first contact portions in contact with a first member and a second member, respectively, and a set of second contact portions in contact with different portions of the second member. The resistance measurement device includes a storage unit configured to store information indicating a relation between a resistance value between the set of second contact portions and a temperature of a joint portion. The resistance measurement device includes a measurement control unit configured to form a state where a first resistance value between the set of first contact portions is measured by a measurement unit and a state where a second resistance value between the set of second contact portions is measured by the measurement unit. The resistance measurement device includes a temperature acquisition unit configured to acquire the temperature of the joint portion based on the measured second resistance value and the information stored in the storage unit, and a calculation unit configured to calculate a reference resistance value based the acquired temperature and the measured first resistance value.

FIG. 1

**Description**

TECHNICAL FIELD

The present invention relates to a resistance measurement device and a resistance measurement method.

BACKGROUND ART

JP1993-115981A discloses a welded portion diagnosis method. In the welded portion diagnosis method, a welding state is determined based on a relation between a heat input amount obtained from a voltage between electrodes and a surface temperature of a welded portion measured by a radiation thermometer.

SUMMARY OF INVENTION

However, it is difficult for a radiation thermometer for measuring a surface temperature to accurately measure the temperature when a measurement target is a metal having a low emissivity. The radiation thermometer can measure only the surface temperature of the measurement target.

Therefore, when correction is performed based on the temperature measured by the radiation thermometer at the time of correcting a measured resistance value of a joint portion by the temperature of the measurement target to acquire a reference resistance value of the joint portion at a reference temperature, for example, the accuracy of the corrected reference resistance value may decrease.

The present invention has been made in view of the above problems, and an object thereof is to improve the temperature correction accuracy.

A resistance measurement device according to an aspect of the present invention is a resistance measurement device that measures a reference resistance value of a joint portion at a predetermined reference temperature in an object in which a first member and a second member are joined to each other, the device including: a connection structure including a set of first contact portions in contact with the first member and the second member, respectively, and a set of second contact portions in contact with different portions of the second member; a measurement unit configured to measure a resistance value between the set of first contact portions and a resistance value between the set of second contact portions; a storage unit configured to store information indicating a relation between the resistance value between the set of second contact portions and a temperature of the joint portion; a measurement control unit configured to form a state where a first resistance value between the set of first contact portions is measured by the measurement unit and a state where a second resistance value between the set of second contact portions is measured by the measurement unit; a temperature acquisition unit configured to acquire the temperature of the joint portion based on the measured second resistance value and the information stored in the storage unit; and a calculation unit configured to calculate the reference resistance value based on the acquired temperature of the joint portion and the measured first resistance value.

In an aspect of the present invention, the resistance value between the set of first contact portions in contact with the first member and the second member and the resistance value between the set of second contact portions in contact with different portions of the second member are measured by the measurement unit. Information indicating the relation between the resistance value between the second contact portions and the temperature of the joint portion of the first member and the second member is stored in the storage unit.

The temperature of the joint portion is acquired based on the second resistance value measured by the measurement unit and the information stored in the storage unit, and the reference resistance value is calculated based on the acquired temperature of the joint portion and the measured first resistance value.

In this manner, the temperature of the joint portion is acquired based on the information indicating the relation between the resistance value between the second contact portions and the temperature of the joint portion. Here, the resistance value between the second contact portions used for acquiring the temperature of the joint portion is obtained based on a current passing through the inside of the second member. Therefore, the temperature of the joint portion is measured with higher accuracy than in a case of measurement with a radiation thermometer capable of measuring only a surface temperature.

The reference resistance value is calculated based on the acquired temperature of the joint portion and the measured first resistance value between the first contact portions. Therefore, the resistance measurement device may improve the temperature correction accuracy as compared with a case where the first resistance value is temperature-corrected based on the surface temperature of the object acquired by the radiation thermometer.

BRIEF DESCRIPTION OF DRAWINGS

[FIG. 1] FIG. 1 is a schematic view illustrating a resistance measurement device according to a first embodiment.

[FIG. 2] FIG. 2 is a block diagram illustrating an example of a hardware configuration of the resistance measurement device.

[FIG. 3] FIG. 3 is a functional block diagram illustrating an example of a functional configuration of the resistance measurement device.

[FIG. 4] FIG. 4 is a flowchart illustrating an example of operations of pre-processing of the resistance measurement device.

[FIG. 5] FIG. 5 is a flowchart illustrating operations following FIG. 4.

[FIG. 6] FIG. 6 is a flowchart illustrating operations following FIG. 5.

[FIG. 7] FIG. 7 is a diagram illustrating a relation between a temperature of a joint portion and a second resistance value.

[FIG. 8] FIG. 8 is a diagram illustrating a procedure for acquiring the temperature of the joint portion at the time of measuring a first resistance value based on the second resistance value measured before and after measuring the first resistance value.

[FIG. 9] FIG. 9 is a diagram illustrating a relation between the temperature of the joint portion and the first resistance value.

[FIG. 10] FIG. 10 is a flowchart illustrating an example of operations of measurement processing of the resistance measurement device.

[FIG. 11] FIG. 11 is a diagram illustrating a change in the second resistance value relative to time when the temperature changes from high to low.

[FIG. 12] FIG. 12 is a diagram illustrating a state where a reference resistance value is obtained from the relation between the temperature of the joint portion and the first resistance value.

[FIG. 13] FIG. 13 is a schematic view illustrating a resistance measurement device according to a second embodiment.

DESCRIPTION OF EMBODIMENTS

(First Embodiment)

Hereinafter, a first embodiment will be described with reference to the accompanying drawings.

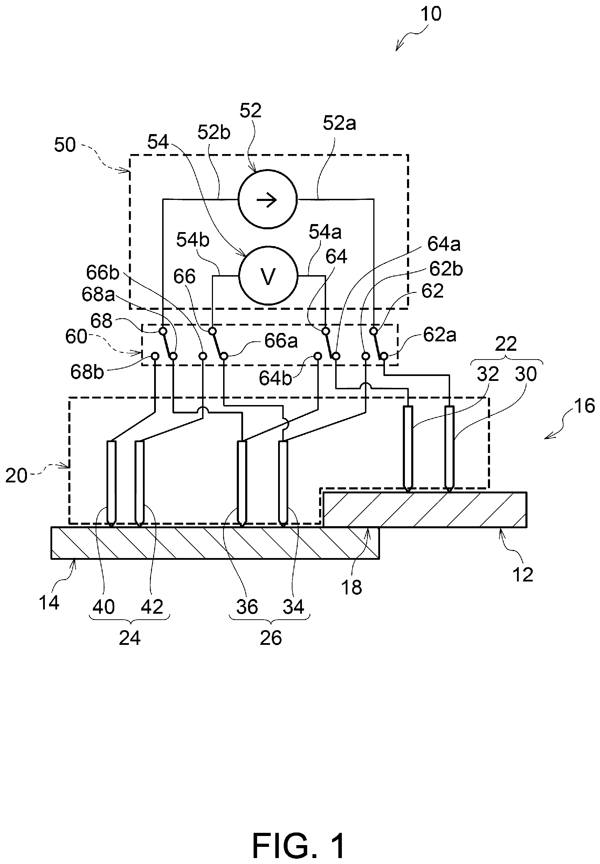

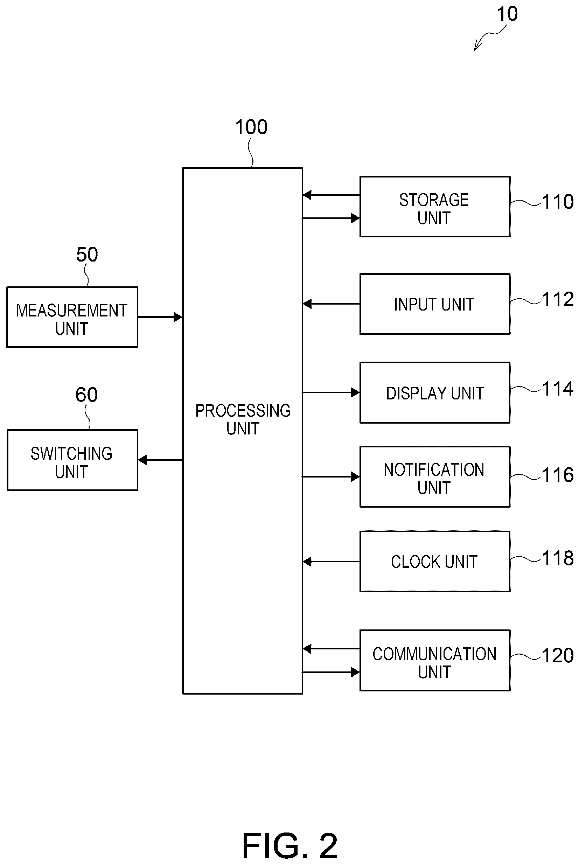

FIG. 1 is a schematic view illustrating a resistance measurement device 10 according to the first embodiment. FIG. 2 is a block diagram illustrating an example of a hardware configuration of the resistance measurement device 10.

As illustrated in FIG. 1, the resistance measurement device 10 is a device that measures a reference resistance value $R_{A0}$ of a joint portion 18 at a predetermined reference temperature $t_0$ in an object 16 in which a first member 12 and a second member 14 are joined to each other.

(Object)

The first member 12 and the second member 14 are members made of metal, and examples of the metal constituting the first member 12 and the second member 14 include copper and aluminum. The first member 12 and the second member 14 may be the same metal or different metals.

Overlapping portions of the first member 12 and the second member 14 are joined by welding, and the joint portion 18 at which the first member 12 and the second member 14 are joint is implemented by a welded portion. It is known that a resistance value of the joint portion 18 indicates a state of the joint portion 18, and a joining state between the first member 12 and the second member 14 can be known by knowing a resistance value of the joint portion 18 at the reference temperature $t_0$.

(Connection Structure)

The resistance measurement device 10 includes a connection structure 20 electrically connected to the object 16. The connection structure 20 has a structure including a set of first contact portions (22, 26) in contact with the first member 12 and the second member 14, respectively, and a set of second contact portions (24, 26) in contact with different portions of the second member 14.

The set of first contact portions (22, 26) can be rephrased as, for example, a set of first contact portions (22, 26). The set of second contact portions (24, 26) can be rephrased as, for example, a set of second contact portions (24, 26).

In the first embodiment, one first contact portion (26) of the set of first contact portions (22, 26) that is in contact with the second member 14 is shared with one second contact portion (26) of the set of second contact portions (24, 26). One first contact portion (26) and one second contact portion (26) are implemented by a common contact portion 26.

The other first contact portion 22 of the set of first contact portions (22, 26) includes a first energization probe 30 and a first measurement probe 32. The common contact portion 26 includes a first common probe 34 and a second common probe 36. The other second contact portion 24 of the set of second contact portions (24, 26) includes a second energization probe 40 and a second measurement probe 42.

The first energization probe 30 is in contact with the first member 12 and is electrically connected to the first member 12. The first measurement probe 32 is in contact with the first member 12 at a position closer to the joint portion 18 than the first energization probe 30, and is electrically connected to the first member 12.

The first common probe 34 is in contact with the second member 14 and is electrically connected to the second member 14. The second common probe 36 is in contact with the second member 14 at a position farther from the joint portion 18 than the first common probe 34, and is electrically connected to the second member 14.

The second measurement probe 42 is in contact with the second member 14 and is electrically connected to the second member 14. The second energization probe 40 is in contact with the second member 14 at a position farther from a contact position of the second common probe 36 than the second measurement probe 42, and is electrically connected to the second member 14.

Accordingly, the first measurement probe 32 and the first common probe 34 are arranged at a predetermined interval between the first energization probe 30 and the second common probe 36. The second common probe 36 and the second measurement probe 42 are arranged at a predetermined interval between the first common probe 34 and the second energization probe 40.

In the first embodiment, a case where the connection structure 20 is implemented by the set of first contact portions (22, 26) and the set of second contact portions (24, 26) has been described, but the first embodiment is not limited thereto. For example, when a set of third contact portions is added, in the object 16 in which a third member is joined to the second member 14 via the joint portion 18, a reference resistance value of the joint portion 18 between the second member 14 and the third member may also be measured.

(Measurement Unit)

The resistance measurement device 10 includes a measurement unit 50 for measuring a resistance value between the set of first contact portions (22, 26) and a resistance value between the set of second contact portions (24, 26).

The measurement unit 50 has a configuration for measuring a resistance value of a measurement portion of the object 16. Methods for measuring a resistance value include a two-terminal method and a four-terminal method, and the measurement unit 50 according to the first embodiment measures the resistance value by the four-terminal method.

The measurement unit 50 includes a supply source 52 that supplies a current flowing through the object 16, and a voltage measurement unit 54 that measures a voltage value at a predetermined portion of the object 16. The supply source 52 is implemented by a constant current source that causes a constant current to flow. For example, the supply source 52 is implemented by a current supply circuit.

The measurement unit 50 may measure the resistance value of the target portion based on the voltage value measured by the voltage measurement unit 54 and a current value of the current flowing from the supply source 52 by causing a constant current to flow from the supply source 52 to the target portion and causing the voltage measurement unit 54 to measure the voltage at the portion where the current from the supply source 52 flows. Accordingly, the measurement unit 50 constitutes a measurement circuit capable of measuring the resistance value between the set of first contact portions (22, 26) and the resistance value between the set of second contact portions (24, 26).

In the first embodiment, a case where the supply source 52 is a constant current source has been described, but the first embodiment is not limited thereto. For example, the supply source 52 may be implemented by a current source that supplies a current and a current measurement unit that measures the current flowing from the current source.

(Switching Unit)

The resistance measurement device 10 includes a switching unit 60. For example, the switching unit 60 is implemented by a switching circuit.

The switching unit 60 selectively forms a first connection state where the set of first contact portions (22, 26) is connected to the measurement unit 50 and a second connection state where the set of second contact portions (24, 26) is connected to the measurement unit 50. The switching unit 60 is implemented by a relay including a first switch 62, a second switch 64, a third switch 66, and a fourth switch 68.

One terminal 52a of the supply source 52 is connected to the first switch 62 of the switching unit 60. The first energization probe 30 is connected to a first contact 62a of the first switch 62, and the first common probe 34 is connected to a second contact 62b of the first switch 62.

One terminal 54a of the voltage measurement unit 54 is connected to the second switch 64 of the switching unit 60. The first measurement probe 32 is connected to a first contact 64a of the second switch 64, and the second common probe 36 is connected to a second contact 64b of the second switch 64.

The other terminal 54b of the voltage measurement unit 54 is connected to the third switch 66 of the switching unit 60. The first common probe 34 is connected to a first contact 66a of the third switch 66, and the second measurement probe 42 is connected to a second contact 66b of the third switch 66.

The other terminal 52b of the supply source 52 is connected to the fourth switch 68 of the switching unit 60. The second common probe 36 is connected to a first contact 68a of the fourth switch 68, and the second energization probe 40 is connected to a second contact 68b of the fourth switch 68.

The first connection state where the set of first contact portions (22, 26) is connected to the measurement unit 50 is formed in a state where the switches 62, 64, 66, 68 are connected to the first contacts 62a, 64a, 66a, 68a, respectively. The second connection state where the set of second contact portions (24, 26) is connected to the measurement unit 50 is formed in a state where the switches 62, 64, 66, and 68 are connected to the second contact points 62b, 64b, 66b, and 68b, respectively.

As illustrated in FIG. 2, the resistance measurement device 10 is centered around a processing unit 100. The measurement unit 50 and the switching unit 60 described above are connected to the processing unit 100.

The processing unit 100 controls a signal output to a coil of the relay constituting the switching unit 60 to operate the switches 62, 64, 66, and 68 (see FIG. 1), thereby switching the switching unit 60 to the first connection state or the second connection state. The processing unit 100 inputs the voltage value measured by the voltage measurement unit 54 of the measurement unit 50, and calculates the resistance value based on the input voltage value and a current value of the current applied from the supply source 52.

The processing unit 100 is connected to a storage unit 110, an input unit 112, a display unit 114, a notification unit 116, a clock unit 118, and a communication unit 120.

The storage unit 110 stores data by the processing unit 100 in a readable manner. The storage unit 110 stores a processing program for controlling the operation of the resistance measurement device 10. The storage unit 110 functions as a storage medium that stores a processing program for implementing a function of the resistance measurement device 10.

The storage unit 110 is implemented by a nonvolatile memory (ROM: Read Only Memory), a volatile memory (RAM: Random Access Memory), or the like. The storage unit 110 stores data used in the processing program in a readable manner.

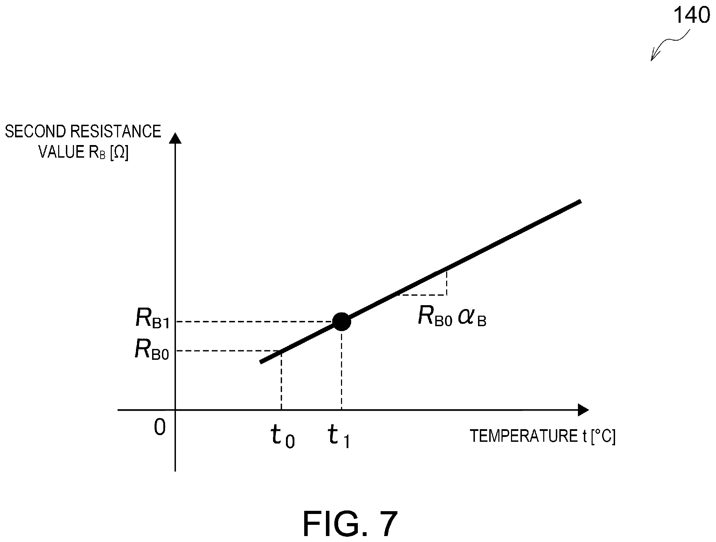

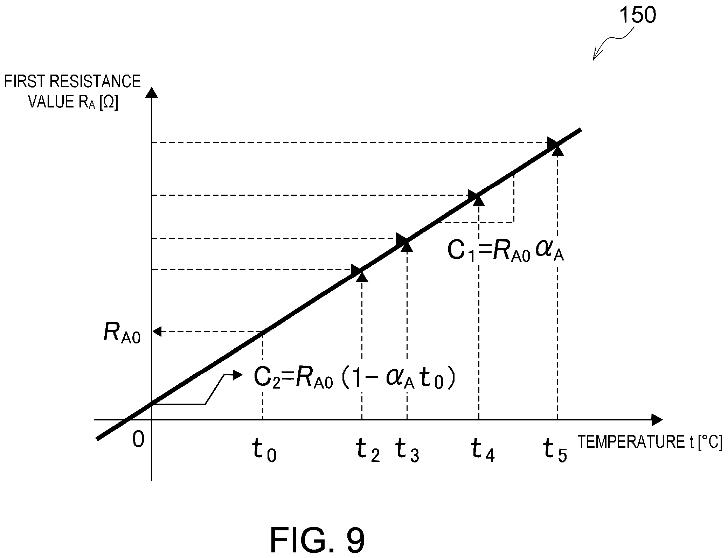

The storage unit 110 stores first information 140 (see FIG. 7), second information 150 (see FIG. 9), a calculation formula, and the like as the data used in the processing program.

The first information 140 (see FIG. 7) is information indicating a relation between a second resistance value $R_B$, which is the resistance value between the set of second contact portions (24, 26), and a temperature t of the joint portion 18. The second information 150 (see FIG. 9) is information indicating a relation between a first resistance value $R_A$, which is the resistance value between the set of first contact portions (22, 26), and the temperature t of the joint portion 18.

The calculation formula is a formula for calculating the reference resistance value $R_{A0}$ based on the first resistance value $R_A$ and the temperature t of the joint portion 18 at the time of measuring the first resistance value $R_A$ (see (Formula 6) described later). By using this calculation formula, the reference resistance value $R_{A0}$ can be calculated based on a resistance temperature coefficient $\alpha_A$ of the joint portion 18 and the reference temperature to.

The input unit 112 transmits data input by a user to the processing unit 100. The input unit 112 functions as an input interface that receives an input operation of the user. The input unit 112 is implemented by, for example, a plurality of operation buttons and numeric buttons, or a touch panel.

The display unit 114 performs display in accordance with the data from the processing unit 100. The display unit 114 displays, for example, a measurement result. Examples of a device constituting the display unit 114 include a display panel such as a light emitting diode or a liquid crystal display (LCD). The display unit 114 according to the first embodiment is implemented by, for example, a liquid crystal panel.

The notification unit 116 performs notification in accordance with the data from the processing unit 100. The notification unit 116 may notify, by sound, the user of guidance or warning sound. Examples of a device for notifying by sound include a piezoelectric buzzer and a speaker. The notification unit 116 according to the first embodiment is implemented by, for example, a speaker.

The clock unit 118 indicates the current date and time and measures time. The clock unit 118 outputs the current date and time to the processing unit 100. The date and time indicated by the clock unit 118 can be stored in the storage unit 110 in association with each measurement value, as the time when each measurement value is measured at the time of measuring the resistance value by the measurement unit 50, for example.

The communication unit 120 enables transmission and reception of data between the processing unit 100 and an external device. The communication unit 120 may output, for example, a measurement result or the like to the external device. The communication unit 120 constitutes an interface for transmitting and receiving data. The communication unit 120 is implemented by hardware that performs communication using a universal serial bus (USB), Bluetooth (registered trademark), a wireless LAN, or the like.

The processing unit 100 is implemented by, for example, a processor. Examples of the processor include a central processing unit (CPU). The processing unit 100 reads the processing program stored in the storage unit 110 and operates in accordance with the read processing program. Accordingly, the processing unit 100 controls each unit of the resistance measurement device 10 to execute the resistance measurement method.

The processing unit 100 can display a measurement result or the like on the display unit 114, notify the measurement result or the like from the notification unit 116, and transmit the measurement result or the like to the external device via the communication unit 120.

(Functional Block)

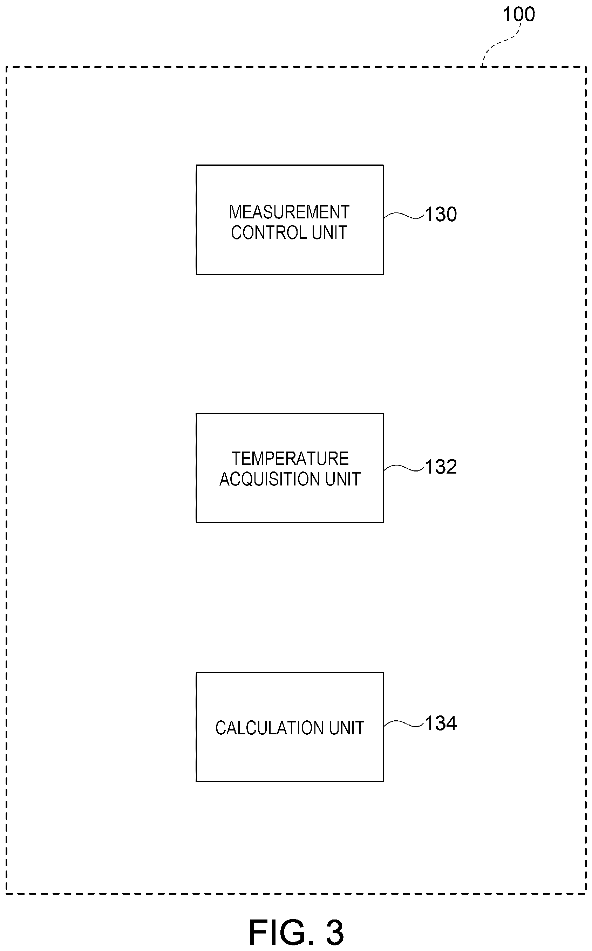

FIG. 3 is a functional block diagram illustrating an example of a functional configuration of the resistance measurement device 10.

As illustrated in FIG. 3, the resistance measurement device 10 includes a measurement control unit 130, a temperature acquisition unit 132, and a calculation unit 134. Functions of the units 130, 132, and 134 in the resistance measurement device 10 are implemented by the processing unit 100 by the processing unit 100 executing a software program read as the processing program from the storage unit 110.

(Measurement Control Unit)

The measurement control unit 130 controls the switching unit 60 to the first connection state, and causes the measurement unit 50 to measure the first resistance value $R_A$ between the set of first contact portions (22, 26). The measurement control unit 130 controls the switching unit 60 to the second connection state, and causes the measurement unit 50 to measure the second resistance value $R_B$ between the set of second contact portions (24, 26).

Accordingly, the measurement control unit 130 forms a state where the first resistance value $R_A$ between the set of first contact portions (22, 26) is measured by the measurement unit 50 and a state where the second resistance value $R_B$ between the set of second contact portions (24, 26) is measured by the measurement unit 50.

In the first embodiment, a case has been described where the measurement control unit 130 controls the switching unit 60 to form a state where the first resistance value $R_A$ is measured by the measurement unit 50 and a state where the second resistance value $R_B$ is measured by the measurement unit 50, but the measurement control unit 130 is not limited to this configuration. The measurement control unit 130 may form, without using the switching unit 60, a state where the first resistance value $R_A$ is measured and a state where the second resistance value $R_B$ is measured. In this case, the state where the first resistance value $R_A$ is measured and the state where the second resistance value $R_B$ is measured may be formed simultaneously or individually.

The measurement control unit 130 alternately switches the connection state of the switching unit 60 to measure the second resistance value $R_B$ before and after measuring the first resistance value $R_A$.

More specifically, the processing unit 100 controls a signal output to the switching unit 60 to connect the switches 62, 64, 66, and 68 to the first contacts 62a, 64a, 66a, and 68a, respectively. Accordingly, the processing unit 100 brings the switching unit 60 into the first connection state, and connects the first contact portion 22 and the common contact portion 26 constituting the set of first contact portions (22, 26) to the measurement unit 50.

In a state where the switching unit 60 is set to the first connection state, the processing unit 100 inputs the voltage value measured by the voltage measurement unit 54 of the measurement unit 50, and calculates the resistance value between the first contact portion 22 and the common contact portion 26 based on the input voltage value and the current value of the current from the supply source 52. The processing unit 100 acquires the calculated resistance value as the first resistance value $R_A$.

The processing unit 100 controls the signal output to the switching unit 60 to connect the switches 62, 64, 66, and 68 to the second contacts 62b, 64b, 66b, and 68b, respectively. Accordingly, the processing unit 100 brings the switching unit 60 into the second connection state, and connects the common contact portion 26 and the second contact portion 24 constituting the set of second contact portions (24, 26) to the measurement unit 50.

In a state where the switching unit 60 is in the second connection state, the processing unit 100 inputs the voltage value measured by the voltage measurement unit 54 of the measurement unit 50. The processing unit 100 calculates the resistance value between the common contact portion 26 and the second contact portion 24 as the second resistance value $R_B$ based on the input voltage value and the current value of the current from the supply source 52.

The processing unit 100 switches the switching unit 60 to measure the second resistance value $R_B$ between the common contact portion 26 and the second contact portion 24 before and after measuring the first resistance value $R_A$ between the first contact portion 22 and the common contact portion 26. That is, the processing unit 100 measures the second resistance value $R_B$ at different timings and measures the first resistance value $R_A$ during that time.

(Temperature Acquisition Unit)

The temperature acquisition unit 132 acquires the temperature t of the joint portion 18 based on the measured second resistance value $R_B$ and the first information 140 (see FIG. 7), which is the information stored in the storage unit 110.

The temperature acquisition unit 132 refers to the information stored in the storage unit 110. Based on this information, the temperature acquisition unit 132 estimates and acquires the temperature t of the joint portion 18 at the time of measuring the first resistance value $R_A$, based on the relation between the second resistance value $R_B$ measured immediately before measuring the first resistance value $R_A$ and the second resistance value $R_B$ measured immediately after measuring the first resistance value $R_A$.

In other words, the temperature acquisition unit 132 refers to the information stored in the storage unit 110. Based on this information, the temperature acquisition unit 132 estimates and acquires the temperature t of the joint portion 18 at the time of measuring the first resistance value $R_A$, by using at least two values including the second resistance value $R_B$ measured immediately before measuring the first resistance value $R_A$ and the second resistance value $R_B$ measured immediately after measuring the first resistance value $R_A$.

Specifically, the first information 140 (see FIG. 7) is information indicating the relation between the second resistance value $R_B$, which is the resistance value between the set of second contact portions (24, 26), and the temperature t of the joint portion 18. The processing unit 100 acquires the temperature t of the joint portion 18 corresponding to the acquired second resistance value $R_B$ by using the first information 140 (see FIG. 7) stored in the storage unit 110.

When the temperature of the joint portion 18 at the time of measuring the first resistance value $R_A$ is acquired with reference to the first information 140 (see FIG. 7) stored in the storage unit 110, the processing unit 100 estimates the temperature t of the joint portion 18 by using at least two values including the second resistance value $R_B$ measured immediately before measuring the first resistance value $R_A$ and the second resistance value $R_B$ measured immediately after measuring the first resistance value $R_A$.

As an example, the processing unit 100 acquires an average value of the second resistance value $R_B$ measured immediately before measuring the first resistance value $R_A$ and the second resistance value $R_B$ measured immediately after measuring the first resistance value $R_A$. Then, the processing unit 100 acquires the temperature t of the joint portion 18 based on the average value and the first information 140 (see FIG. 7).

(Calculation Unit)

The calculation unit 134 calculates the reference resistance value $R_{A0}$ based on the acquired temperature t of the joint portion 18 and the measured first resistance value $R_A$. For this calculation, for example, a calculation formula (for example, see Formula 6 described later) stored in the storage unit 110 is used.

The calculation unit 134 calculates the reference resistance value $R_{A0}$ based on the acquired temperature t of the joint portion 18, the measured first resistance value $R_A$, and the calculation formula stored in the storage unit 110.

Specifically, the processing unit 100 inputs, to the calculation formula stored in the storage unit 110, the measured first resistance value $R_A$ and the temperature t of the joint portion 18 at the time of measuring the first resistance value $R_A$, and calculates the reference resistance value $R_{A0}$. The temperature t of the joint portion 18 acquired by the temperature acquisition unit 132 can be used as the temperature t of the joint portion 18 input to the calculation formula.

(Description of Operation)

Next, the operation of the resistance measurement device 10 will be described in accordance with a processing procedure to be executed by the processing unit 100.

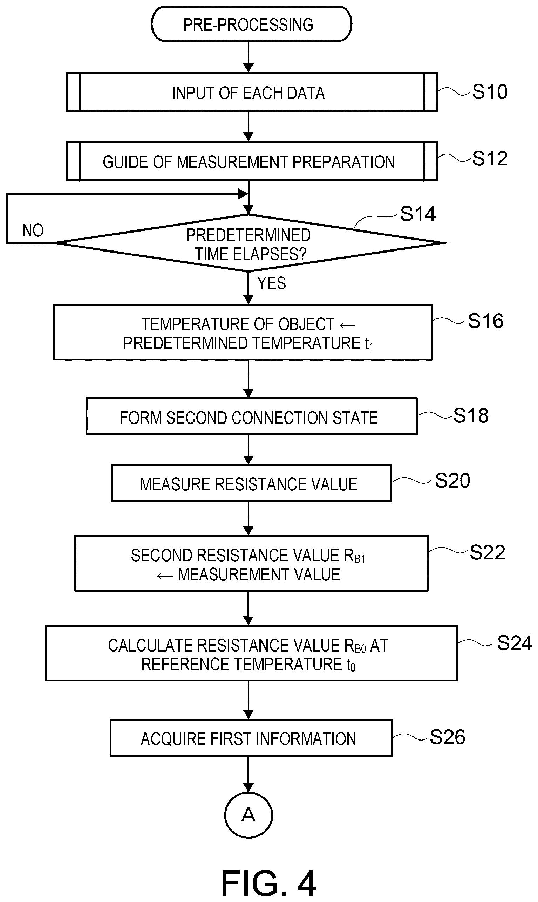

The resistance measurement device 10 performs pre-processing for acquiring the first information 140 (see FIG. 7), the second information 150 (see FIG. 9), the calculation formula, and the like described above at a stage before starting measurement. The pre-processing will be described with reference to FIGS. 4 to 9.

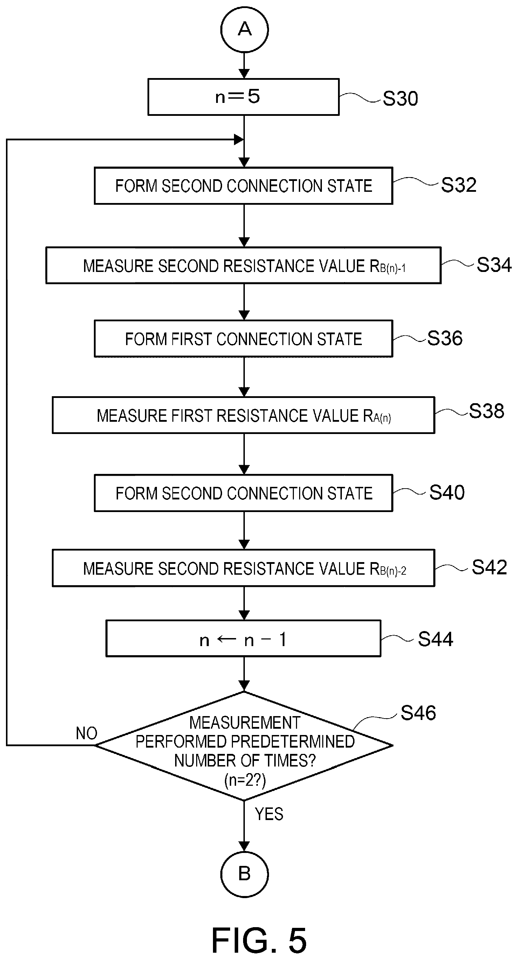

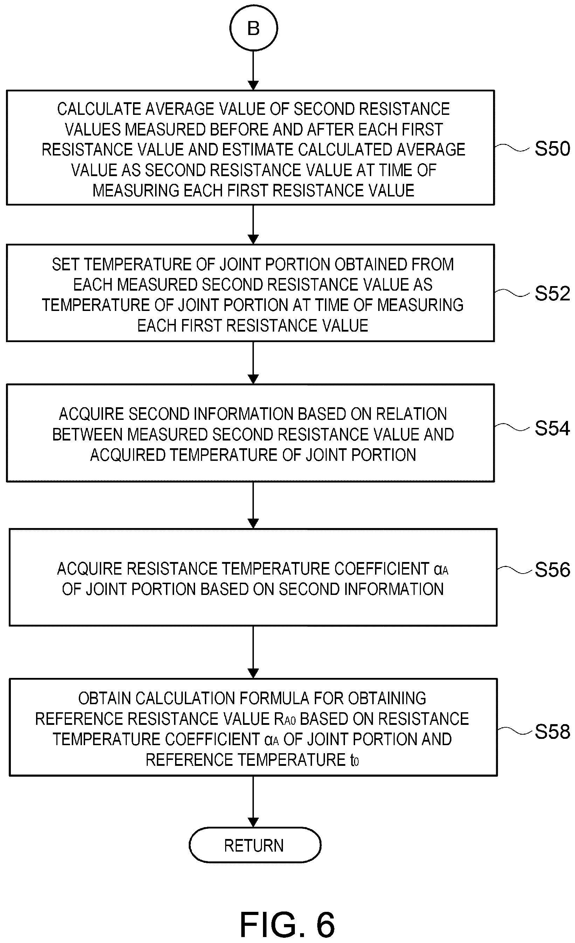

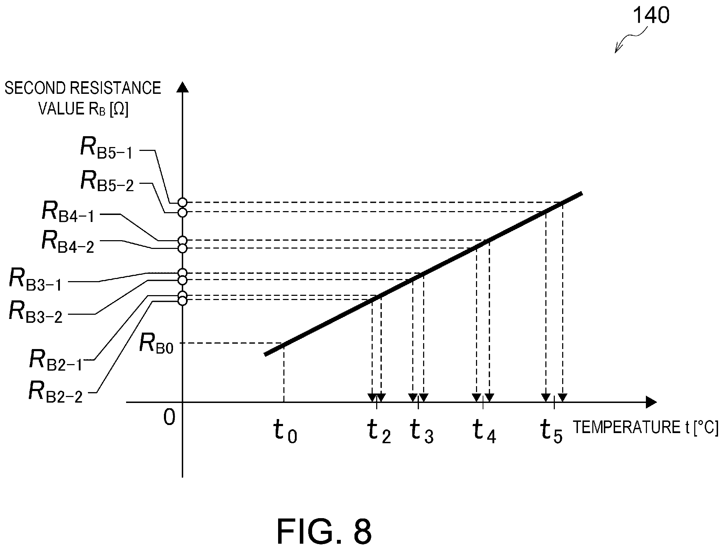

FIG. 4 is a flowchart illustrating an example of operations of the pre-processing of the resistance measurement device 10. FIG. 5 is a flowchart illustrating operations following FIG. 4. FIG. 6 is a flowchart illustrating operations following FIG. 5. FIG. 7 is a diagram illustrating the relation between the temperature t of the joint portion 18 and the second resistance value $R_B$. FIG. 8 is a diagram illustrating a procedure for acquiring the temperature t of the joint portion 18 at the time of measuring the first resistance value $R_A$, based on the second resistance value $R_B$ measured before and after measuring the first resistance value $R_A$. FIG. 9 is a diagram illustrating the relation between the temperature t of the joint portion 18 and the first resistance value $R_A$.

As illustrated in FIG. 4, the processing unit 100 executes a main routine according to the processing program stored in the storage unit 110, executes the pre-processing called from the main routine, and then performs data input processing (step S10).

In the data input processing, the processing unit 100 displays, on the display unit 114, for example, an input screen for requesting input of the reference temperature $t_0$ (for example, 20°C) which is any temperature and a resistance temperature coefficient $\alpha_B$ of the second member 14, which is known. Then, when the reference temperature $t_0$ and the resistance temperature coefficient $\alpha_B$ are input from the input unit 112 by a user, the processing unit 100 stores the input reference temperature $t_0$ and resistance temperature coefficient $\alpha_B$ in the storage unit 110.

The processing unit 100 displays guidance for performing measurement preparation on the display unit 114 (step S12).

Specifically, the processing unit 100 guides the first energization probe 30 to come into contact with the first member 12, and guides the first measurement probe 32 to come into contact with the first member 12 at a position closer to the joint portion 18 than the first energization probe 30. In addition, the processing unit 100 guides the first common probe 34 to come into contact with the second member 14, and guides the second common probe 36 to come into contact with the second member 14 at a position farther from the joint portion 18 than the first common probe 34. Further, the processing unit 100 guides the second measurement probe 42 to come into contact with the second member 14, and guides the second energization probe 40 to come into contact with the second member 14 at a position farther from a contact position of the second common probe 36 than the second measurement probe 42.

The processing unit 100 guides the object 16 to be left for a predetermined time in a chamber in which the room temperature is stable at a predetermined temperature $t_1$. The predetermined time is set to a time required for the object 16 left in the chamber to reach the predetermined temperature $t_1$.

Then, the processing unit 100 determines whether the predetermined time elapses since the object 16 is left in the chamber at the predetermined temperature $t_1$ (step S14). When it is determined in step S14 that the predetermined time elapses, the processing unit 100 stores the temperature of the object 16 in the storage unit 110 as the predetermined temperature $t_1$ (step S16).

Here, the first member 12 and the second member 14 constituting the object 16 are made of metal having high thermal conductivity such as copper or aluminum. Therefore, the temperature of the object 16, a temperature of the first member 12, a temperature of the second member 14, and the temperature of the joint portion 18 at which the first member 12 and the second member 14 are joined to each other are substantially the same temperature. A temperature between the common contact portion 26 and the second contact portion 24 and a temperature between the first contact portion 22 and the common contact portion 26 are also substantially the same temperature as the temperature of the object 16.

The processing unit 100 controls an output signal to the switching unit 60 to bring the switching unit 60 into the second connection state, and connects the common contact portion 26 and the second contact portion 24 to the measurement unit 50 (step S18).

In a state where the switching unit 60 is in the second connection state, the processing unit 100 inputs the voltage value measured by the voltage measurement unit 54 of the measurement unit 50. Then, the processing unit 100 calculates a resistance value between the common contact portion 26 and the second contact portion 24 based on the input voltage value and a current value of a current flowing from the supply source 52 (step S20). The processing unit 100 stores the calculated resistance value in the storage unit 110 as the second resistance value $R_{B1}$ of the second member 14 when the temperature is the predetermined temperature $t_1$ (step S22).

Then, the processing unit 100 calculates the reference resistance value $R_{B0}$ of the second member 14 at the reference temperature $t_0$ using a formula for obtaining a resistance temperature coefficient (step S24). Here, the resistance temperature coefficient refers to a rate of change when the resistance value changes with a change in temperature.

Specifically, the processing unit 100 calculates the reference resistance value $R_{B0}$ of the second member 14 when the temperature of the object 16 is the reference temperature $t_0$, by using (Formula 1) shown below obtained from the formula for obtaining the resistance temperature coefficient.

[Math. 1]

$$R_{B0} = \frac{R_{B1}}{1+\alpha_B \times (t_1-t_0)} \quad \cdot\ \cdot\ \cdot \quad (\text{Formula 1})$$

$R_{B0}$ indicates the reference resistance value of the second member 14 at the reference temperature $t_0$. $\alpha_B$ indicates the resistance temperature coefficient of the second member 14. $t_1$ indicates the predetermined temperature that is the temperature of the object 16. $t_0$ indicates the reference temperature input in step S10. $R_{B1}$ indicates the second resistance value of the second member 14 measured at the predetermined temperature $t_1$.

As illustrated in FIG. 7, the processing unit 100 generates the first information 140 which is information based on the reference temperature $t_0$, the resistance temperature coefficient $\alpha_B$, the predetermined temperature $t_1$, the second resistance value $R_{B1}$ at the predetermined temperature $t_1$, and the reference resistance value $R_{B0}$, and stores the first information 140 in the storage unit 110 (step S26).

In FIG. 7, $R_B$ indicates the resistance value between the common contact portion 26 and the second contact portion 24. t indicates the temperature between the common contact portion 26 and the second contact portion 24.

The first information 140 stored in the storage unit 110 may be implemented by a graph, a data group, or a data table indicating a relation among the reference temperature $t_0$, the resistance temperature coefficient $\alpha_B$, the predetermined temperature $t_1$, the second resistance value $R_{B1}$ at the predetermined temperature $t_1$, and the reference resistance value $R_{B0}$.

Next, the processing unit 100 alternately measures the first resistance value $R_A$ between the first contact portion 22 and the common contact portion 26 and the second resistance value $R_B$ between the common contact portion 26 and the second contact portion 24 in the object 16 in which the temperature changes, and store the first resistance value $R_A$ and the second resistance value $R_B$ in the storage unit 110.

As a method for measuring the first resistance value $R_A$ and the second resistance value $R_B$ while changing the temperature of the object 16, for example, a method for measuring the first resistance value $R_A$ and the second resistance value $R_B$ during a cooling period after welding the joint portion 18 between the first member 12 and the second member is exemplified. Examples of the cooling period include a period in which the temperature of the object 16 decreases to a specific temperature immediately after welding the first member 12 and the second member 14.

As illustrated in FIG. 5, the processing unit 100 inputs a numerical value "5" to a storage region n secured in the storage unit 110 (step S30). Then, the processing unit 100 controls an output signal to the switching unit 60 to bring the switching unit 60 into the second connection state, and connects the common contact portion 26 and the second contact portion 24 to the measurement unit 50 (step S32).

In the second connection state, the processing unit 100 inputs the voltage value measured by the voltage measurement unit 54 of the measurement unit 50. The processing unit 100 sets, as a second resistance value $R_{B(n)-1}$, a resistance value between the common contact portion 26 and the second contact portion 24 calculated based on the voltage value and the current value of the current flowing from the supply source 52 (step S34).

Here, the numerical value stored in the storage region n of the storage unit 110 is populated in "$_{(n)}$" of $R_{B(n)-1}$.

The processing unit 100 controls the output signal to the switching unit 60 to bring the switching unit 60 into the first connection state, and connects the first contact portion 22 and the common contact portion 26 to the measurement unit 50 (step S36).

In the first connection state, the processing unit 100 inputs the voltage value measured by the voltage measurement unit 54 of the measurement unit 50. The processing unit 100 sets the calculated resistance value between the first contact portion 22 and the common contact portion 26 as a first resistance value $R_{A(n)}$ based on the voltage value and the current value of the current flowing from the supply source 52 (step S38).

Here, the numerical value stored in the storage region n of the storage unit 110 is populated in "$_{(n)}$" of $R_{A(n)}$.

The processing unit 100 controls the output signal to the switching unit 60 to bring the switching unit 60 into the second connection state, and connects the common contact portion 26 and the second contact portion 24 to the measurement unit 50 (step S40).

In the second connection state, the processing unit 100 inputs the voltage value measured by the voltage measurement unit 54 of the measurement unit 50. The processing unit 100 sets the calculated resistance value between the common contact portion 26 and the second contact portion 24 as a second resistance value $R_{B(n)-2}$ based on the voltage value and the current value of the current flowing from the supply source 52 (step S42).

Here, the numerical value stored in the storage region n of the storage unit 110 is populated in "$_{(n)}$" of $R_{B(n)-2}$.

Then, the processing unit 100 subtracts "1" from the numerical value stored in the storage region n (step S44), and determines whether a predetermined number of measurements is completed based on whether the numerical value stored in the storage region n is "2" (step S46).

In step S46, when the numerical value stored in the storage region n is not "2", the process branches to step S32 and the processing unit 100 performs each step until the measurement of the number of times of measurement (for example, four times) is completed.

Accordingly, the processing unit 100 acquires a second resistance value $R_{B5-1}$, a first resistance value $R_{A5}$, a second resistance value $R_{B5-2}$, a second resistance value $R_{B4-1}$, a first resistance value $R_{A4}$, a second resistance value $R_{B4-2}$..., and stores the values in the storage unit 110.

When it is determined in step S46 that the numerical value of the storage region n is "2", the processing unit 100 estimates the second resistance value $R_B$ at the time of measuring the predetermined first resistance value $R_A$, based on the relation between the second resistance value $R_B$ measured immediately before measuring the predetermined first resistance value $R_A$ and the second resistance value $R_B$ measured immediately after measuring the predetermined first resistance value $R_A$.

Accordingly, the processing unit 100 estimates the second resistance value $R_B$ at the time of measuring the predetermined first resistance value $R_A$, by using at least two values including the second resistance value $R_B$ measured immediately before measuring the predetermined first resistance value $R_A$ and the second resistance value $R_B$ measured immediately after measuring the predetermined first resistance value $R_A$.

As illustrated in FIG. 6, the processing unit 100 calculates an average value of the second resistance value $R_B$ measured before and after the first resistance value $R_A$, and estimates the calculated average value as the second resistance value $R_B$ at the time of measuring the first resistance value $R_A$ (step S50).

Specifically, the processing unit 100 calculates an average value by dividing, by "2", a value obtained by adding the second resistance value $R_{B5-1}$ and the second resistance value $R_{B5-2}$ measured before and after the first resistance value $R_{A5}$, and estimates the calculated average value as the second resistance value $R_{B5}$ at the time of measuring the first resistance value $R_{A5}$. The processing unit 100 estimates the second resistance values $R_{B2}$ to $R_{B5}$ for the respective first resistance value $R_{A2}$ to $R_{A5}$.

Then, the processing unit 100 sets, based on the first information 140 stored in the storage unit 110, temperatures $t_2$ to $t_5$ of the joint portion 18 obtained from the respective estimated second resistance value $R_{B2}$ to $R_{B5}$ as the temperatures $t_2$ to $t_5$ of the joint portion 18 at the time of measuring the corresponding first resistance value $R_{A2}$ to $R_{A5}$ (step S52).

As illustrated in FIG. 8, the temperature t of the object 16 decreases over time. Therefore, the temperature t of the object 16 at the time of measuring the second resistance value $R_{B5-1}$ may be different from the temperature t of the object 16 at the time of measuring the first resistance value $R_{A5}$.

Therefore, the processing unit 100 calculates an average value of the second resistance value $R_{B5-1}$ and the second resistance value $R_{B5-2}$ measured before and after the first resistance value $R_{A5}$. The processing unit 100 estimates the calculated average value as the second resistance value $R_{B5}$ at the time of measuring the first resistance value $R_{A5}$, and acquires the temperature $t_5$ of the joint portion 18 at the time of measuring the first resistance value $R_{A5}$.

In the first embodiment, a case where measurement performed in the order of the second resistance value $R_B$, the first resistance value $R_A$, and the second resistance value $R_B$ is set as one cycle and the measurement cycle is repeated four times has been described, but the first embodiment is not limited thereto.

For example, a measurement cycle in which measurement on the second resistance value $R_B$ and measurement on the first resistance value $R_A$ are alternately performed may be performed a plurality of times, and in this case, the number of times of measurement on the second resistance value $R_B$ can be reduced.

The second resistance value $R_B$ at the time of measuring the first resistance value $R_A$ may be obtained based on a relation between a time from the previous measurement on the second resistance value $R_B$ to the measurement on the first resistance value $R_A$ and a time from the measurement on the first resistance value $R_A$ to the subsequent measurement on the second resistance value $R_B$.

Then, the processing unit 100 acquires the second information 150 (see FIG. 9) based on the relation between the measured first resistance value $R_A$ and the acquired temperature t of the joint portion 18 (step S54).

Specifically, the processing unit 100 acquires a correspondence relation between the measured first resistance value $R_A$ and the estimated temperature t of the joint portion 18, generates the second information 150 (see FIG. 9), and stores the second information 150 in the storage unit 110 (step S54).

FIG. 9 illustrates an example of the second information 150 indicating the correspondence relation between the measured first resistance value $R_A$ and the estimated temperature t of the joint portion 18.

Then, the processing unit 100 acquires, based on the second information 150, a resistance temperature coefficient between the common contact portion 26 and the second contact portion 24 as the resistance temperature coefficient $\alpha_A$ of the joint portion 18 that is dominant between the common contact portion 26 and the second contact portion 24 (step S56).

Accordingly, a coefficient calculation unit that calculates the resistance temperature coefficient $\alpha_A$ of the joint portion 18 based on data indicating a relation among the plurality of first resistance values $R_A$ and the plurality of second resistance values $R_B$ in time series obtained by alternately switching the connection state of the switching unit 60 is implemented by the function of the processing unit 100.

Specifically, the second information 150 indicating the correspondence relation between the first resistance value $R_A$ and the temperature t of the joint portion 18 can be expressed by the following (Formula 2) indicating a straight line. The straight line expressed by (Formula 2) can be acquired by using, for example, the least squares method.

$$R_A = C_1 \times t + C_2 \quad (\text{Formula 2})$$

$R_A$ indicates the first resistance value. $C_1$ indicates a slope of the straight line indicating the second information 150 (see FIG. 9). $C_2$ indicates an intercept of the straight line indicating the second information 150 (see FIG. 9).

A linear formula obtained from the formula for obtaining the resistance temperature coefficient is shown in the following (Formula 3).

$$R_A = R_{A0} \times \{1 + \alpha_A \times (t - t_0)\} \ (\text{Formula 3})$$

$R_A$ indicates the first resistance value. $R_{A0}$ indicates the reference resistance value of the joint portion 18 which is dominant between the common contact portion 26 and the first contact portion 22 at the reference temperature $t_0$ (for example, 20°C). $\alpha_A$ indicates the resistance temperature coefficient of the joint portion 18 which is dominant between the common contact portion 26 and the first contact portion 22. t indicates the temperature of the joint portion 18 between the common contact portion 26 and the first contact portion 22. $t_0$ indicates the reference temperature of the joint portion 18 between the common contact portion 26 and the first contact portion 22.

Then, a simultaneous equation of the two formulas (Formula 2) and (Formula 3) is solved to obtain the following (Formula 4).

[Math. 2]

$$\alpha_A = \frac{C_1}{C_1 \times t_0 + C_2} \qquad \cdot \cdot \cdot \quad (\text{Formula 4})$$

The calculation process is shown below.

$R_A = R_{A0} \times \{1 + \alpha_A \times (t - t_0)\}$ is converted to obtain the following (Formula 5).

$$R_A = R_{A0} \times \alpha_A \times t + R_{A0} \times (1 - \alpha_A \times t_0) \quad (\text{Formula 5})$$

Since it is known that $C_1$ indicates "$R_{A0} \times \alpha_A$" from "$R_A = C_1 \times t + C_2$" in (Formula 5) and (Formula 2), a formula of "$R_{A0} = C_1/\alpha_A$" is obtained.

Since $C_2$ indicates "$R_{A0} \times (1 - \alpha_A \times t_0)$", "$C_2 = C_1/\alpha_A \times (1 - \alpha_A \times t_0) = C_1/\alpha_A - C_1 \times t_0$" is obtained by substituting "$R_{A0} = C_1/\alpha_A$" into the formula of $C_2$.

When this formula is transformed, "$C_2 + C_1 \times t_0 = C_1/\alpha_A$" is obtained, and when this formula is further transformed, (Formula 4) described above is obtained.

Here, the temperature t is acquired based on the second resistance value $R_B$ between the second contact portion 24 and the common contact portion 26. Therefore, the state inside the second member 14 is reflected in the temperature t.

Then, the processing unit 100 obtains a calculation formula for obtaining the reference resistance value $R_{A0}$ based on the resistance temperature coefficient $\alpha_A$ of the joint portion 18 and the reference temperature $t_0$, stores the obtained calculation formula in the storage unit 110 (step S58), ends the pre-processing, and returns to the main routine.

Specifically, the processing unit 100 obtains a calculation formula for obtaining the reference resistance value $R_{A0}$ from the measured first resistance value ($R_{A6}$) and the temperature ($t_6$) of the joint portion 18 by using a formula for obtaining the resistance temperature coefficient, and stores the calculation formula in the storage unit 110. This calculation formula is shown in the following (Formula 6).

[Math. 3]

$$R_{A0} = \frac{R_{A6}}{1 + \alpha_A \times (t_6 - t_0)} \qquad \cdot \cdot \cdot \quad (\text{Formula 6})$$

$R_{A0}$ indicates the reference resistance value when the joint portion 18 is at the reference temperature $t_0$. $R_{A6}$ indicates the measured first resistance value. $t_6$ indicates the temperature of the joint portion 18 at the time of measuring the first resistance value $R_{A6}$. $\alpha_A$ indicates the resistance temperature coefficient of the joint portion 18 that is dominant between the common contact portion 26 and the first contact portion 22. $t_0$ indicates the reference temperature of the joint portion 18 between the common contact portion 26 and the first contact portion 22.

(Measurement Processing)

Next, measurement processing of measuring a reference resistance value $R_{A0}'$ of the joint portion 18 in the object 16 will be described.

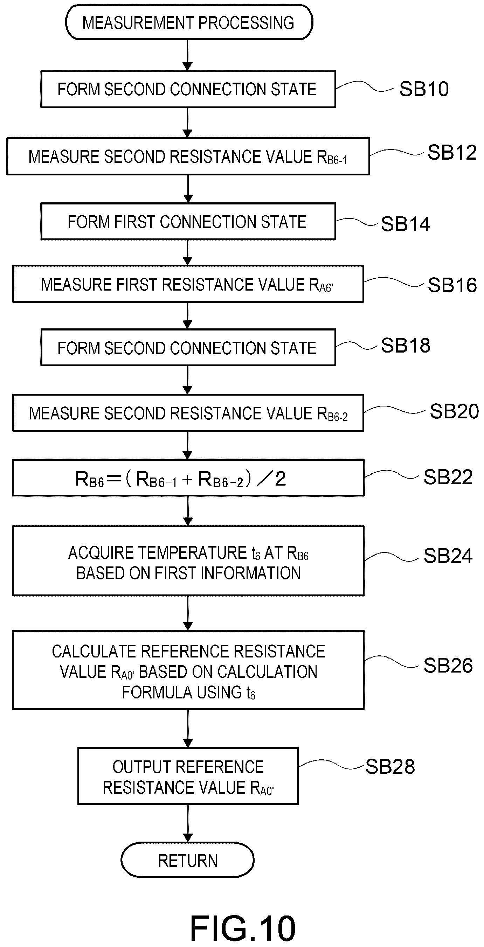

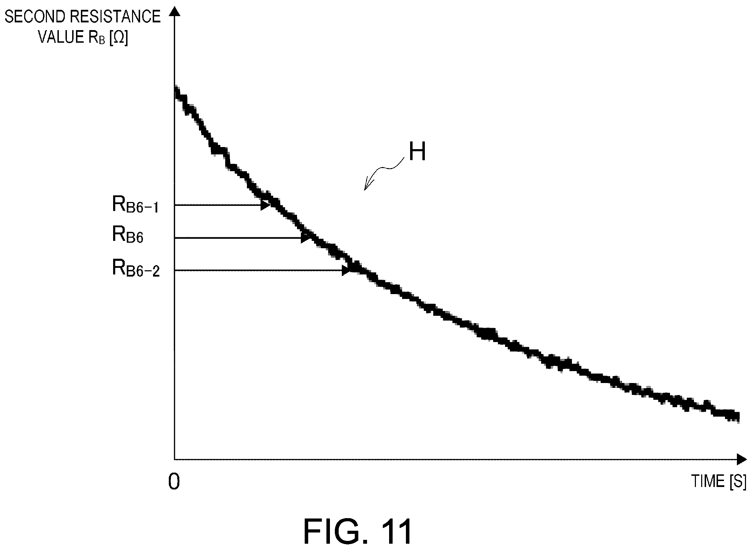

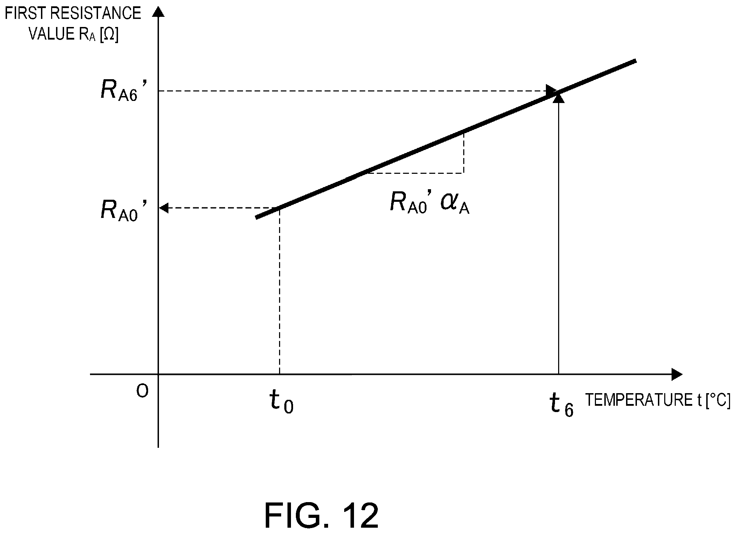

FIG. 10 is a flowchart illustrating an example of operations of the measurement processing of the resistance measurement device 10. FIG. 11 is a diagram illustrating a change in the second resistance value $R_B$ relative to time when the temperature changes from high to low. FIG. 12 is a diagram illustrating a state where the reference resistance value $R_{A0}'$ is obtained from the relation between the temperature t of the joint portion 18 and the first resistance value $R_A$.

That is, in response to the measurement processing being called from the main routine, the processing unit 100 controls an output signal to the switching unit 60 to bring the switching unit 60 into the second connection state, and connects the common contact portion 26 and the second contact portion 24 to the measurement unit 50 (step SB10).

In the second connection state, the processing unit 100 inputs the voltage value measured by the voltage measurement unit 54 of the measurement unit 50. The processing unit 100 sets the calculated resistance value between the common contact portion 26 and the second contact portion 24 as a second resistance value $R_{B6-1}$ based on the voltage value and the current value of the current flowing from the supply source 52 (step SB12).

The processing unit 100 controls the output signal to the switching unit 60 to bring the switching unit 60 into the first connection state, and connects the first contact portion 22 and the common contact portion 26 to the measurement unit 50 (step SB14).

In the first connection state, the processing unit 100 inputs the voltage value measured by the voltage measurement unit 54 of the measurement unit 50. The processing unit 100 sets the calculated resistance value between the first contact portion 22 and the common contact portion 26 as a first resistance value $R_{A6}'$ based on the voltage value and the current value of the current flowing from the supply source 52 (step SB16).

Further, the processing unit 100 controls the output signal to the switching unit 60 to bring the switching unit 60 into the second connection state, and connects the common contact portion 26 and the second contact portion 24 to the measurement unit 50 (step SB18).

In the second connection state, the processing unit 100 inputs the voltage value measured by the voltage measurement unit 54 of the measurement unit 50. The processing unit 100 sets the calculated resistance value between the common contact portion 26 and the second contact portion 24 as a second resistance value $R_{B6-2}$ based on the voltage value and the current value of the current flowing from the supply source 52 (step SB20).

The processing unit 100 estimates a second resistance value $R_{B6}$ at the time of measuring the first resistance value $R_{A6}'$, based on a relation between the second resistance value $R_{B6-1}$ measured immediately before measuring the first resistance value $R_{A6}'$ and the second resistance value $R_{B6-2}$ measured immediately after measuring the first resistance value $R_{A6}'$ (step SB22).

Accordingly, the processing unit 100 estimates the second resistance value $R_{B6}$ at the time of measuring the first resistance value $R_{A6}'$, by using two values including the second resistance value $R_{B6-1}$ measured immediately before measuring the first resistance value $R_{A6}'$ and the second resistance value $R_{B6-2}$ measured immediately after measuring the first resistance value $R_{A6}'$.

Specifically, the processing unit 100 adds the second resistance value $R_{B6-1}$ and the second resistance value $R_{B6-2}$, and sets a value obtained by dividing the added value by "2" as the second resistance value $R_{B6}$. Accordingly, an average value of the second resistance value $R_{B6-1}$ and the second resistance value $R_{B6-2}$ measured before and after each first resistance value $R_{A6}'$ is calculated, and the calculated average value is estimated as the second resistance value $R_{B6}$ at the time of measuring the first resistance value $RA6'$.

Next, the processing unit 100 acquires the temperature $t_6$ of the joint portion 18 based on the estimated second resistance value $R_{B6}$ by using the first information 140 (see FIG. 8) stored in the storage unit 110 (step SB24). In FIG. 8, the second resistance value $R_{B6}$ and the temperature $t_6$ of the joint portion 18 are not illustrated.

As illustrated in FIG. 11, when the object 16 shifts from a high temperature to a low temperature, the change in the temperature of the object 16 increases in a high-temperature region H. Therefore, in response to a time difference occurring between the measurement on the second resistance value $R_B$ for measuring the temperature $t$ of the joint portion 18 and the measurement on the first resistance value $R_A$ for inspecting the state of the joint portion 18, a large difference may occur between the temperature $t$ at the time of measuring the second resistance value $R_B$ and the temperature $t$ at the time of measuring the first resistance value $R_A$.

Therefore, the processing unit 100 calculates an average value of the second resistance value $R_{B6-1}$ and the second resistance value $R_{B6-2}$ measured before and after the first resistance value $R_{A6}'$. Then, the processing unit 100 acquires the temperature $t$ of the joint portion 18 by using the calculated average value as the second resistance value $R_{B6}$ at the time of measuring the first resistance value $R_{A6}'$, thereby enabling highly accurate measurement.

Next, the processing unit 100 substitutes the acquired temperature $t_6$ of the joint portion 18 and the measured first resistance value $R_{A6}'$ into the calculation formula (see Formula 6) stored in the storage unit 110 to calculate the reference resistance value $R_{A0}'$ of the joint portion 18 at the reference temperature $t_0$ and obtain a measurement result (step SB26).

As illustrated in FIG. 12, the reference resistance value $R_{A0}'$ of the joint portion 18 at the reference temperature $t_0$ can be obtained based on the temperature $t_6$ of the joint portion 18, the measured first resistance value $R_{A6}'$, and the resistance temperature coefficient $\alpha_A$ of the joint portion 18.

Then, the processing unit 100 outputs a measurement result by displaying the calculated reference resistance value $R_{A0}'$ on the display unit 114, notifying the reference resistance value $R_{A0}'$ from the notification unit 116, or transmitting the reference resistance value $R_{A0}'$ to the external device via the communication unit 120 (step SB28), and returns to the main routine.

(Functions and Effects)

Next, functions and effects of the first embodiment will be described.

The resistance measurement device 10 according to the first embodiment is a device that measures the reference resistance value $R_{A0}$ of the joint portion 18 at the predetermined reference temperature $t_0$ in the object 16 in which the first member 12 and the second member 14 are joined to each other. The resistance measurement device 10 includes the connection structure 20 including a set of first contact portions (22, 26) in contact with the first member 12 and the second member 14, respectively, and a set of second contact portion (24, 26) in contact with different portions of the second member 14. The resistance measurement device 10 includes the measurement unit 50 for measuring a resistance value between the set of first contact portions (22, 26) and a resistance value between the set of second contact portions (24, 26). The resistance measurement device 10 includes the storage unit 110 that stores information (140) indicating a relation between the resistance value between the set of second contact portions (24, 26) and the temperature t of the joint portion 18.

The resistance measurement device 10 includes the measurement control unit 130 that forms a state where the first resistance value $R_A$ between the set of first contact portions (22, 26) is measured by the measurement unit 50 and a state where the second resistance value $R_B$ between the set of second contact portions (24, 26) is measured by the measurement unit 50. The resistance measurement device 10 includes the temperature acquisition unit 132 that acquires the temperature t of the joint portion 18 based on the measured second resistance value $R_B$ and the information (140) stored in the storage unit 110. The resistance measurement device 10 includes the calculation unit 134 that calculates the reference resistance value $R_{A0}$ based on the acquired temperature t of the joint portion 18 and the measured first resistance value $R_A$.

A resistance measurement method according to the first embodiment is a measurement method for measuring the reference resistance value $R_{A0}$ of the joint portion 18 at the predetermined reference temperature $t_0$ in the object 16 in which the first member 12 and the second member 14 are joined to each other. In the resistance measurement method, a set of first contact portions (22, 26) being in contact with the first member 12 and the second member 14, respectively, and a set of second contact portions (24, 26) being in contact with different portions of the second member 14, the method including a step of measuring, by the measurement unit 50, a resistance value between the set of first contact portions (22, 26) and a resistance value between the set of second contact portions (24, 26), a step of selectively switching between a first connection state where the set of first contact portions (22, 26) is connected to the measurement unit 50 and a second connection state where the set of second contact portions (24, 26) is connected to the measurement unit 50, and a step of storing information (140) indicating a relation between the resistance value between the set of second contact portions (24, 26) and the temperature t of the joint portion 18.

The resistance measurement method further includes a measurement control step (steps SB10 to SB20) of measuring the first resistance value $R_A$ between the set of first contact portions (22, 26) and measuring the second resistance value $R_B$ between the set of second contact portions (24, 26). The resistance measurement method further includes a temperature acquisition step (steps SB22 to SB24) of acquiring the temperature t of the joint portion 18 based on the measured second resistance value $R_B$ and the stored information. The resistance measurement method further includes a calculation step (step SB26) of calculating the reference resistance value $R_{A0}$ based on the acquired temperature t of the joint portion 18 and the measured first resistance value $R_A$.

In the resistance measurement device 10 and the resistance measurement method with these configurations, the first resistance value $R_A$ between the set of first contact portions (22, 26) in contact with the first member 12 and the second member 14 and the second resistance value $R_B$ between the set of second contact portions (24, 26) in contact with different portions of the second member 14 are measured by the measurement unit 50. The information (140) indicating a relation between the second resistance value $R_B$ between the second contact portions (24, 26) and the temperature t of the joint portion 18 between the first member 12 and the second member 14 is stored in, for example, the storage unit 110.

The temperature of the joint portion 18 is acquired based on the second resistance value $R_B$ measured by the measurement unit 50 and, for example, the information (140) stored in the storage unit 110, and the reference resistance value $R_{A0}$ is calculated based on the acquired temperature of the joint portion 18 and the measured first resistance value $R_A$.

In this manner, the temperature of the joint portion 18 is acquired based on the information (140) indicating the relation between the temperature t of the joint portion 18 and the second resistance value $R_B$ between the second contact portions (24, 26). Here, the second resistance value $R_B$ between the second contact portions (24, 26) used for acquiring the temperature of the joint portion 18 is obtained based on a current passing through the inside of the second member 14. Therefore, the temperature of the joint portion 18 is measured with higher accuracy than in the case of measurement with a radiation thermometer capable of measuring only a surface temperature.

Here, in the first embodiment, the first member 12 and the second member 14 constituting the object 16 are formed of a metal having a low emissivity. In this manner, when the temperature of the object 16 formed of a metal is measured by a radiation thermometer, it is difficult to accurately measure the temperature. However, in the first embodiment, the temperature of the joint portion 18 is acquired based on the information (140) indicating the relation between the temperature t of the joint portion 18 and the second resistance value $R_B$ between the second contact portions (24, 26). Therefore, the temperature of the joint portion 18 is measured with higher accuracy than in the case of measurement with a radiation thermometer.

The reference resistance value $R_{A0}$ is calculated based on the acquired temperature of the joint portion 18 and the measured first resistance value $R_A$ between the first contact portions (22, 26). Therefore, according to the resistance measurement device 10 and the resistance measurement method, the temperature correction accuracy can be improved as compared with the case where the measured first resistance value $R_A$ is temperature-corrected based on the surface temperature of the object 16 acquired by the radiation thermometer.

The resistance measurement device 10 according to the first embodiment further includes the switching unit 60 that selectively switches between a first connection state where the set of first contact portions (22, 26) is connected to the measurement unit 50 and a second connection state where the set of second contact portions (24, 26) is connected to the measurement unit 50. The measurement control unit 130 controls the switching unit 60 to the first connection state to form a state where the first resistance value $R_A$ is measured by the measurement unit 50, and controls the switching unit 60 to the second connection state to form a state where the second resistance value $R_B$ is measured by the measurement unit 50.

In this configuration, the resistance measurement device 10 includes the switching unit 60 that selectively switches between the first connection state where the set of first contact portions (22, 26) is connected to the measurement unit 50 and the second connection state where the set of second contact portions (24, 26) is connected to the measurement unit 50.

Then, at the time of measuring the first resistance value $R_A$ between the set of first contact portions (22, 26), the resistance measurement device 10 controls the switching unit 60 to the first connection state to cause a current from the measurement unit 50 to flow between the set of first contact portions (22, 26), thereby measuring the first resistance value $R_A$. At the time of measuring the second resistance value $R_B$ between the set of second contact portions (24, 26), the resistance measurement device 10 controls the switching unit 60 to the second connection state to cause a current from the measurement unit 50 to flow between the set of second contact portions (24, 26), thereby measuring the second resistance value $R_B$.

In this manner, the resistance measurement device 10 does not cause the current for measuring the first resistance value $R_A$ and the current for measuring the second resistance value $R_B$ to flow through the object 16 at the same time.

Therefore, as compared with a structure in which a current for measuring the first resistance value $R_A$ and a current for measuring the second resistance value $R_B$ flow through the object 16 at the same time, interference between the current for measuring the first resistance value $R_A$ and the current for measuring the second resistance value $R_B$ is avoided. Accordingly, the resistance measurement device 10 may prevent the influence caused by current interference.

Since only one measurement unit 50 is required to measure a resistance value, it is possible to reduce the size and the cost as compared with a case where a plurality of measurement units 50 are required.

Further, as compared with a case where the first resistance value $R_A$ and the second resistance value $R_B$ are measured by different measurement units 50, it is possible to prevent addition of measurement errors that may occur in the measurement units, which may improve the measurement accuracy.

Furthermore, it is possible to simplify the control as compared with a case where due to a structure including the plurality of measurement units 50, it is necessary to adjust a measurement timing of each measurement unit at the time of measuring the first resistance value $R_A$ and the second resistance value $R_B$.

In the resistance measurement device 10 according to the first embodiment, one first contact portion (26) of the set of first contact portions (22, 26), which is in contact with the second member 14, is shared with one second contact portion (26) of the set of second contact portions (24, 26).

In this configuration, one (26) of the set of first contact portions (22, 26), which is in contact with the second member 14, and one (26) of the set of second contact portions (24, 26) are shared. Therefore, the number of contact portions in contact with the object 16 can be reduced, so that cost reduction can be implemented. The number of contact portions with the object 16 is reduced, so that measurement may be performed even in a narrow place.

In the resistance measurement device 10 according to the first embodiment, the storage unit 110 stores a calculation formula (for example, (Formula 6)) for calculating the reference resistance value $R_{A0}$ based on the first resistance value $R_A$ and the temperature of the joint portion 18 at the time of measuring the first resistance value $R_A$. The calculation unit 134 calculates the reference resistance value $R_{A0}$ based on the acquired temperature t of the joint portion 18, the measured first resistance value $R_A$, and the calculation formula stored in the storage unit 110.

In this configuration, the reference resistance value $R_{A0}$ can be calculated, by using the calculation formula stored in the storage unit 110, based on the measured first resistance value $R_A$ and the temperature of the joint portion 18 at the time of measuring the first resistance value $R_A$.

Therefore, the amount of data stored in the storage unit 110 may be reduced as compared with a case where the reference resistance value $R_{A0}$ is obtained by using a data table, a graph, or the like for obtaining the reference resistance value $R_{A0}$.

In the resistance measurement device 10 according to the first embodiment, the measurement control unit 130 alternately switches the connection state of the switching unit 60 to measure the second resistance value $R_B$ before and after measuring the first resistance value $R_A$. The temperature acquisition unit 132 estimates and acquires, by referring to the information (140) stored in the storage unit 110, the temperature t of the joint portion 18 at the time of measuring the first resistance value $R_A$ based on a relation between the second resistance value $R_B$ measured immediately before measuring the first resistance value $R_A$ and the second resistance value $R_B$ measured immediately after measuring the first resistance value $R_A$.

In this configuration, when the object 16 shifts from a high temperature to a low temperature, a change in the temperature of the object 16 increases in the high-temperature region H. Therefore, in response to a time difference occurring between the measurement on the second resistance value $R_B$ for measuring the temperature t of the joint portion 18 and the measurement on the first resistance value $R_A$ for inspecting the state of the joint portion 18, a large difference may occur between the temperature t at the time of measuring the second resistance value $R_B$ and the temperature t at the time of measuring the first resistance value $R_A$.

Therefore, the temperature of the joint portion 18 can be acquired with high accuracy by estimating the temperature t of the joint portion 18 at the time of measuring the first resistance value $R_{A6}$, based on a relation between the second resistance value $R_{B6-1}$ and the second resistance value $R_{B6-2}$ measured before and after measuring the first resistance value $R_{A6}$. Accordingly, with the resistance measurement device 10, the measurement accuracy of the reference resistance value $R_{A0}$ may be improved.

In the resistance measurement device 10 according to the first embodiment, the relation between the second resistance value $R_B$ measured immediately before measuring the first resistance value $R_A$ and the second resistance value $R_B$ measured immediately after measuring the first resistance value $R_A$ is an average value of the second resistance value $R_B$ measured before and after measuring the first resistance value $R_A$. In response to acquiring the average value of the second resistance value $R_B$, the temperature acquisition unit 132 acquires, by referring to the information (140) stored in the storage unit 110, the temperature t of the joint portion 18 corresponding to the average value as the temperature t of the joint portion 18 at the time of measuring the first resistance value $R_A$.

In this configuration, the temperature t of the joint portion 18 at the time of measuring the first resistance value $R_A$ can be acquired based on the average value of the second resistance value $R_B$ measured immediately before measuring the first resistance value $R_A$ and the second resistance value $R_B$ measured immediately after measuring the first resistance value $R_A$. Therefore, it is possible to improve the measurement accuracy of the reference resistance value $R_{A0}$ while simplifying the calculation.

The resistance measurement device 10 according to the first embodiment further includes a coefficient calculation unit that calculates the resistance temperature coefficient $\alpha_A$ of the joint portion 18 based on the data indicating the relation between the acquired plurality of first resistance values $R_A$ and plurality of second resistance values $R_B$ in time series. As described above, the coefficient calculation unit is implemented by the processing unit 100 by the processing unit 100 operating in accordance with a processing program stored in the storage unit 110.

In this configuration, the resistance measurement device 10 calculates the resistance temperature coefficient $\alpha_A$ of the joint portion 18 based on, for example, time series data of the first resistance value $R_A$ and the second resistance value $R_B$ obtained by alternately switching the connection state of the switching unit 60. Therefore, it is possible to improve the calculation accuracy of the resistance temperature coefficient $\alpha_A$ as compared with a case where the resistance temperature coefficient of the joint portion 18 is calculated based on the first resistance value $R_A$ and the second resistance value $R_B$ obtained by different measurement units 50.

The resistance measurement method according to the first embodiment further includes a first information acquisition step (steps S14 to S26) of acquiring the first information 140 indicating the relation between the second resistance value $R_B$ and the temperature t of the joint portion 18. The resistance measurement method further includes a first preliminary measurement step (steps S32 to S34) of measuring the second resistance value $R_B$ by the measurement unit 50 in the second connection state. The resistance measurement method further includes a second preliminary measurement step (steps S36 to S38) of measuring the first resistance value $R_A$ by the measurement unit 50 by switching to the first connection state after the first preliminary measurement step. The resistance measurement method further includes a third preliminary measurement step (steps S40 to S42) of measuring the second resistance value $R_B$ by the measurement unit 50 by switching to the second connection state after the second preliminary measurement step. The resistance measurement method further includes a preliminary estimation step (step S50) of estimating, as the second resistance value $R_B$, the resistance value between the second contact portions (24, 26) at the time of measuring the first resistance value $R_A$ in the second preliminary measurement step, by using at least two values including the second resistance value $R_B$ measured in the first preliminary measurement step and the second resistance value $R_B$ measured in the third preliminary measurement step.

In this configuration, when the object 16 shifts from a high temperature to a low temperature, the change in the temperature of the object 16 increases in the high-temperature region H. Therefore, in response to a time difference occurring between the measurement on the second resistance value $R_B$ for measuring the temperature t of the joint portion 18 and the measurement on the first resistance value $R_A$ for inspecting the state of the joint portion 18, a large difference may occur between the temperature t at the time of measuring the second resistance value $R_B$ and the temperature t at the time of measuring the first resistance value $R_A$.

Therefore, in the resistance measurement method, the resistance value between the second contact portions (24, 26) at the time of measuring the first resistance value $R_A$ is estimated as the second resistance value $R_B$ by using at least two values including the second resistance values $R_B$ measured before and after the first resistance value $R_A$. Accordingly, since the temperature of the joint portion 18 at the time of measuring the first resistance value $R_A$ can be acquired by using the second resistance value $R_B$, the temperature of the joint portion 18 can be acquired with high accuracy.

The resistance measurement method according to the first embodiment further includes a preliminary temperature acquisition step (step S52) of acquiring the temperature t of the joint portion 18 at the time of measuring the first resistance value $R_A$ in the second preliminary measurement step, based on the second resistance value $R_B$ estimated in the preliminary estimation step and the first information 140. The resistance measurement method further includes a resistance temperature coefficient calculation step (step S56) of calculating the resistance temperature coefficient $\alpha_A$ of the joint portion 18 based on the second information 150 indicating a relation between the first resistance value $R_A$ and the temperature t of the joint portion 18. The resistance measurement method further includes a formula storage step (step S58) of storing a calculation formula for calculating the reference resistance value $R_{A0}$ based on the resistance temperature coefficient $\alpha_A$ of the joint portion 18 acquired in the resistance temperature coefficient calculation step and the reference temperature $t_0$.

In this configuration, since the temperature t of the joint portion 18 at the time of measuring the first resistance value $R_A$ in the second preliminary measurement step can be acquired based on the second resistance value $R_B$ estimated in the preliminary estimation step and the first information 140, the temperature of the joint portion 18 can be acquired with high accuracy.

Then, in the resistance measurement method, the resistance temperature coefficient $\alpha_A$ of the joint portion 18 is calculated based on the second information 150 indicating the relation between the first resistance value $R_A$ and the temperature t of the joint portion 18. In the resistance measurement method, a calculation formula for calculating the reference resistance value $R_{A0}$ based on the resistance temperature coefficient $\alpha_A$ and the reference temperature $t_0$ is stored in, for example, the storage unit 110.

Therefore, the reference resistance value $R_{A0}$ can be calculated, for example, by using the calculation formula stored in the storage unit 110, based on the measured first resistance value $R_A$ and the temperature t of the joint portion 18 at the time of measuring the first resistance value $R_A$. Therefore, the amount of data stored in the storage unit 110 can be reduced as compared with a case where the reference resistance value $R_{A0}$ is obtained using a data table, a graph, or the like for obtaining the reference resistance value $R_{A0}$.

In the resistance measurement method according to the first embodiment, the first information acquisition step includes a predetermined temperature measurement step (steps S14 to S12) of measuring the second resistance value $R_B$ by the measurement unit 50 in the second connection state in a state where the object 16 is set to the predetermined temperature $t_1$. The resistance measurement method further includes an information generation step (steps S24 to S26) of generating the first information 140 based on the second resistance value $R_B$ measured in the predetermined temperature measurement step, the predetermined temperature $t_1$, the resistance temperature coefficient $\alpha_A$ of the second member 14, and the reference temperature $t_0$.

In this configuration, since the first information 140 is generated based on the second resistance value $R_B$ measured by bringing the switching unit 60 into the second connection state, for example, it is possible to generate the first information 140 in the same measurement environment as the second information 150.

Therefore, as compared with a case where the first information 140 and the second information 150 are generated based on measurement values measured in different measurement environments, it is possible to suppress an influence on the first information 140 and the second information 150 that may be caused by a measurement error.

In the resistance measurement method according to the first embodiment, the first preliminary measurement step to the third preliminary measurement step are acquired during a period in which the joint portion 18 in which the first member 12 and the second member 14 are joined to each other is cooled.

In this configuration, for example, in a case where the first member 12 and the second member 14 are joined by welding, a change in the temperature occurs when the temperature of the object 16 heated to a high temperature by the heat of welding decreases. Therefore, the first resistance value $R_A$ and the second resistance value $R_B$ can be measured while changing the temperature of the object 16 by using a process in which the object 16 heated to a high temperature by the heat of welding is cooled.

Accordingly, a time immediately after welding may be effectively used. It is unnecessary to apply heat to the object 16 or cool the object 16.

(Second Embodiment)

Next, a second embodiment will be described.

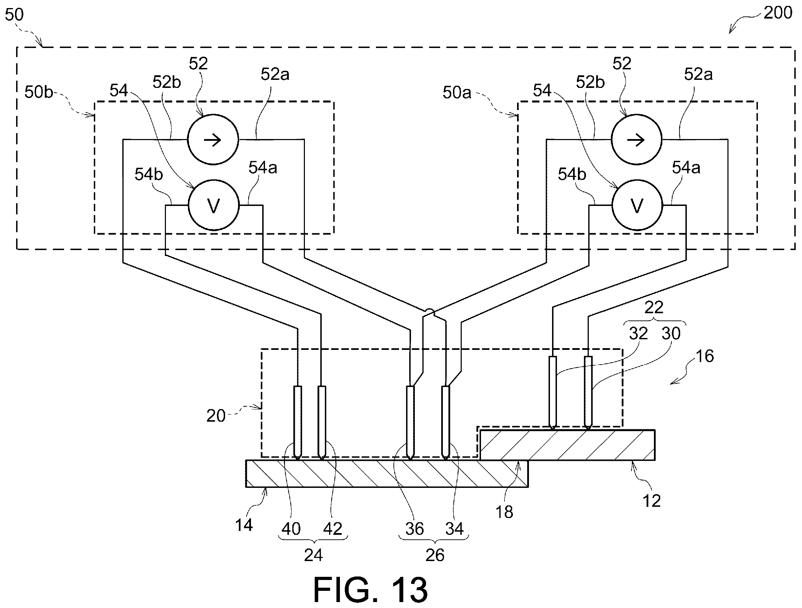

FIG. 13 is a schematic view illustrating a resistance measurement device 200 according to the second embodiment. In the resistance measurement device 200 according to the second embodiment, the same or equivalent portions as those of the first embodiment are denoted by the same reference numerals, description thereof is omitted, and only different portions will be described.

As illustrated in FIG. 13, the resistance measurement device 200 is different from the first embodiment in that the measurement unit 50 includes a first measurement unit 50a and a second measurement unit 50b.

The measurement unit 50 of the resistance measurement device 200 includes the first measurement unit 50a that measures a resistance value between a set of first contact portions (22, 26), and the second measurement unit 50b that measures a resistance value between a set of second contact portions (24, 26). The first measurement unit 50a and the second measurement unit 50b are implemented in the same manner as in the first embodiment.

One terminal 52a of the supply source 52 in the first measurement unit 50a is connected to the first energization probe 30. The other terminal 52b of the supply source 52 in the first measurement unit 50a is connected to the second common probe 36.

One terminal 54a of the voltage measurement unit 54 in the first measurement unit 50a is connected to the first measurement probe 32. The other terminal 54b of the voltage measurement unit 54 in the first measurement unit 50a is connected to the first common probe 34.

One terminal 52a of the supply source 52 in the second measurement unit 50b is connected to the first common probe 34. The other terminal 52b of the supply source 52 in the second measurement unit 50b is connected to the second energization probe 40.

One terminal 54a of the voltage measurement unit 54 in the second measurement unit 50b is connected to the second common probe 36. The other terminal 54b of the voltage measurement unit 54 in the second measurement unit 50b is connected to the second measurement probe 42.

The measurement control unit 130 (see FIG. 3) alternately operates the first measurement unit 50a and the second measurement unit 50b to measure the second resistance value $R_B$ between the set of second contact portions (24, 26) before and after measuring the first resistance value $R_A$ between the set of first contact portions (22, 26). The first measurement unit 50a and the second measurement unit 50b are operated by a control signal from the processing unit 100.

The first measurement unit 50a supplies a current from the supply source 52 to the object 16 in an operation state. In the operation state, the first measurement unit 50a measures a voltage value at a predetermined portion of the object 16 by the voltage measurement unit 54, and sends the measured voltage value to the processing unit 100 (see FIG. 2).

The second measurement unit 50b supplies a current from the supply source 52 to the object 16 in the operation state. In the operation state, the second measurement unit 50b measures a voltage value at a predetermined portion of the object 16 by the voltage measurement unit 54, and sends the measured voltage value to the processing unit 100 (see FIG. 2).

The temperature acquisition unit 132 (see FIG. 3) refers to information (140) stored in the storage unit 110 (see FIG. 2) (see FIG. 8). Accordingly, the temperature acquisition unit 132 (see FIG. 3) estimates and acquires the temperature t of the joint portion 18 at the time of measuring the first resistance value $R_A$, based on an average value of the second resistance value $R_B$ measured immediately before measuring the first resistance value $R_A$ and the second resistance value $R_B$ measured immediately after measuring the first resistance value $R_A$.

As described above, functions of the measurement control unit 130 and the temperature acquisition unit 132 (see FIG. 3) are implemented by the processing unit 100 (see FIG. 2) executing a software program read from the storage unit 110 (see FIG. 2).

(Functions and Effects)

Functions and effects of the second embodiment will be described.

In the second embodiment, the same functions and effects as those of the first embodiment can also be exerted for the same or equivalent portions as those of the first embodiment.

In the resistance measurement device 200 according to the second embodiment, the measurement unit 50 includes the first measurement unit 50a that measures a resistance value between a set of first contact portions (22, 26), and the second measurement unit 50b that measures a resistance value between a set of second contact portions (24, 26). The measurement control unit 130 alternately operates the first measurement unit 50a and the second measurement unit 50b to measure the second resistance value $R_B$ before and after measuring the first resistance value $R_A$. The temperature acquisition unit 132 estimates and acquires, by referring to information (140) stored in the storage unit 110, the temperature t of the joint portion 18 at the time of measuring the first resistance value $R_A$ based on an average value of the second resistance value $R_B$ measured immediately before measuring the first resistance value $R_A$ and the second resistance value $R_B$ measured immediately after measuring the first resistance value $R_A$.

In this configuration, the measurement unit 50 includes the first measurement unit 50a that measures a resistance value between a set of first contact portions (22, 26) and the second measurement unit 50b that measures a resistance value between a set of second contact portions (24, 26). Therefore, as compared with a case where the measurement unit 50 is implemented by one unit, the switching unit 60 that switches between the first contact portion (22, 26) and the second contact portion (24, 26) connected to the measurement unit 50 is unnecessary. Accordingly, it is possible to reduce the cost of the resistance measurement device 200.

The measurement control unit 130 alternately operates the first measurement unit 50a and the second measurement unit 50b to measure the second resistance value $R_B$ before and after measuring the first resistance value $R_A$. Therefore, as compared with a case where a current for measuring the first resistance value $R_A$ and a current for measuring the second resistance value $R_B$ flow through the object 16 at the same time, interference between the current for measuring the first resistance value $R_A$ and the current for measuring the second resistance value $R_B$ can be avoided. Accordingly, the measurement control unit 130 may suppress the influence caused by current interference.

Although the embodiments of the present invention have been described above, the above embodiments merely exemplify some of application examples of the present invention and do not intend to limit the technical scope of the present invention to the specific configurations of the above embodiments.

The present application claims priority based on Japanese Patent Application No. 2022-144045 filed to the Japan Patent Office on Sep. 9, 2022 and priority based on Japanese Patent Application No. 2023-100106 filed to the Japan Patent Office on Jun. 19, 2023, and all contents of these applications are incorporated herein by reference.

DESCRIPTION OF REFERENCE SIGNS

10      resistance measurement device

12      first member
14      second member
16      object
18      joint portion
20      connection structure
22      first contact portion
24      second contact portion
26      common contact portion
50      measurement unit
50a     first measurement unit
50b     second measurement unit
54      voltage measurement unit
60      switching unit
100     processing unit
110     storage unit
130     measurement control unit
132     temperature acquisition unit
134     calculation unit
140     first information
150     second information
$R_A$      first resistance value
$R_{A0}$     reference resistance value
$R_B$      second resistance value
$t_0$       reference temperature
$t_1$       predetermined temperature

**Claims**

1.  A resistance measurement device that measures a reference resistance value of a joint portion at a predetermined reference temperature in an object in which a first member and a second member are joined to each other, the resistance measurement device comprising:

    a connection structure including a set of first contact portions in contact with the· first member and the second member, respectively, and a set of second contact portions in contact with different portions of the second member;

a measurement unit configured to measure a resistance value between the set of first contact portions and a resistance value between the set of second contact portions;

a storage unit configured to store information indicating a relation between the resistance value between the set of second contact portions and a temperature of the joint portion;

a measurement control unit configured to form a state where a first resistance value between the set of first contact portions is measured by the measurement unit and a state where a second resistance value between the set of second contact portions is measured by the measurement unit;

a temperature acquisition unit configured to acquire the temperature of the joint portion based on the measured second resistance value and the information stored in the storage unit; and

a calculation unit configured to calculate the reference resistance value based on the acquired temperature of the joint portion and the measured first resistance value.

2. The resistance measurement device according to claim 1, further comprising:

a switching unit configured to selectively switch between a first connection state where the set of first contact portions is connected to the measurement unit and a second connection state where the set of second contact portions is connected to the measurement unit, wherein

the measurement control unit controls the switching unit to the first connection state to form the state where the first resistance value is measured by the measurement unit, and controls the switching unit to the second connection state to form the state where the second resistance value is measured by the measurement unit.

3. The resistance measurement device according to claim 2, wherein
one first contact portion of the set of first contact portions, which is in contact with the second member, is shared with one second contact portion of the set of second contact portions.

4. The resistance measurement device according to claim 2 or 3, wherein

the storage unit stores a calculation formula for calculating the reference resistance value based on the first resistance value and the temperature of the joint portion at the time of measuring the first resistance value, and

the calculation unit calculates the reference resistance value based on the acquired temperature of the joint portion, the measured first resistance value, and the calculation formula stored in the storage unit.

5. The resistance measurement device according to any one of claims 2 to 4, wherein

the measurement control unit
alternately switches the connection state of the switching unit to measure the second resistance value before and after measuring the first resistance value, and
the temperature acquisition unit
estimates and acquires, by referring to the information stored in the storage unit, the temperature of the joint portion at the time of measuring the first resistance value, based on a relation between the second resistance value measured immediately before measuring the first resistance value and the second resistance value measured immediately after measuring the first resistance value.

6. The resistance measurement device according to claim 5, wherein

the relation between the second resistance value measured immediately before measuring the first resistance value and the second resistance value measured immediately after measuring the first resistance value is an average value of the second resistance value measured before and after measuring the first resistance value, and

in response to acquiring the average value of the second resistance value, the temperature acquisition unit acquires, by referring to the information stored in the storage unit, the temperature of the joint portion corresponding to the average value as the temperature of the joint portion at the time of measuring the first resistance value.

7. The resistance measurement device according to claim 1, wherein

the measurement unit includes a first measurement unit configured to measure the resistance value between the set of first contact portions and a second measurement unit configured to measure the resistance value between the set of second contact portions,

the measurement control unit

alternately operates the first measurement unit and the second measurement unit to measure the second resistance value before and after measuring the first resistance value, and

the temperature acquisition unit

estimates and acquires, by referring to the information stored in the storage unit, the temperature of the joint portion at the time of measuring the first resistance value, based on an average value of the second resistance value measured immediately before measuring the first resistance value and the second resistance value measured immediately after measuring the first resistance value.

8. The resistance measurement device according to any one of claims 1 to 7, further comprising:

a coefficient calculation unit configured to calculate a resistance temperature coefficient of the joint portion based on data indicating a relation between a plurality of the acquired first resistance values and a plurality of the acquired second resistance values in time series.

9. A resistance measurement method for measuring a reference resistance value of a joint portion at a predetermined reference temperature in an object in which a first member and a second member are joined to each other, a set of first contact portions being in contact with the first member and the second member, respectively, and a set of second contact portions being in contact with different portions of the second member, the method comprising:

a step of measuring, by a measurement unit, a resistance value between the set of first contact portions and a resistance value between the set of second contact portions;

a step of selectively switching between a first connection state where the set of first contact portions is connected to the measurement unit and a second connection state where the set of second contact portions is connected to the measurement unit;

a step of storing information indicating a relation between the resistance value between the set of second contact portions and a temperature of the joint portion;

a measurement control step of measuring a first resistance value between the set of first contact portions and measuring a second resistance value between the set of second contact portions;

a temperature acquisition step of acquiring the temperature of the joint portion based on the measured second resistance value and the stored information; and

a calculation step of calculating the reference resistance value based on the acquired temperature of the joint portion and the measured first resistance value.

10. The resistance measurement method according to claim 9, further comprising:

a first information acquisition step of acquiring first information indicating a relation between the second resistance value and the temperature of the joint portion;

a first preliminary measurement step of measuring the second resistance value by the measurement unit in the second connection state;

a second preliminary measurement step of measuring the first resistance value by the measurement unit by switching to the first connection state after the first preliminary measurement step;

a third preliminary measurement step of measuring the second resistance value by the measurement unit by switching to the second connection state after the second preliminary measurement step; and

a preliminary estimation step of estimating, as the second resistance value, a resistance value between the second contact portions at the time of measuring the first resistance value in the second preliminary measurement step, by using at least two values including the second resistance value measured in the first preliminary measurement step and the second resistance value measured in the third preliminary measurement step.

11. The resistance measurement method according to claim 10, further comprising:

a preliminary temperature acquisition step of acquiring the temperature of the joint portion at the time of measuring the first resistance value in the second preliminary measurement step, based on the second resistance value estimated in the preliminary estimation step and the first information;

a resistance temperature coefficient calculation step of calculating a resistance temperature coefficient of the joint portion based on second information indicating a relation between the first resistance value and the temperature of the joint portion; and

a formula storage step of storing a calculation formula for calculating the reference resistance value based on the resistance temperature coefficient of the joint portion acquired in the resistance temperature coefficient calculation step and the reference temperature.

**12.** The resistance measurement method according to claim 10 or 11, wherein

the first information acquisition step includes
a predetermined temperature measurement step of measuring the second resistance value by the measurement unit in the second connection state in a state where the object is set to a predetermined temperature, and
an information generation step of generating the first information based on the second resistance value measured in the predetermined temperature measurement step, the predetermined temperature, a resistance temperature coefficient of the second member, and the reference temperature.

**13.** The resistance measurement method according to any one of claims 10 to 12, wherein
the first preliminary measurement step to the third preliminary measurement step are acquired during a period in which the joint portion at which the first member and the second member are joined to each other is cooled.

FIG. 1

FIG. 2

100

MEASUREMENT
CONTROL UNIT ～130

TEMPERATURE
ACQUISITION UNIT ～132

CALCULATION UNIT ～134

FIG. 3

```
        ┌─────────────────────────────┐
        │       PRE-PROCESSING        │
        └─────────────────────────────┘
                      │
                      ▼
    ┌─────────────────────────────────────┐
    │        INPUT OF EACH DATA           │───S10
    └─────────────────────────────────────┘
                      │
                      ▼
    ┌─────────────────────────────────────┐
    │   GUIDE OF MEASUREMENT PREPARATION  │───S12
    └─────────────────────────────────────┘
                      │
          ┌───────────▼──────────────┐
     NO   ◁     PREDETERMINED        ▷      S14
    ◁─────      TIME ELAPSES?        
          └───────────┬──────────────┘
                     YES
                      ▼
    ┌─────────────────────────────────────┐
    │     TEMPERATURE OF OBJECT ←         │───S16
    │   PREDETERMINED TEMPERATURE t₁      │
    └─────────────────────────────────────┘
                      │
                      ▼
    ┌─────────────────────────────────────┐
    │     FORM SECOND CONNECTION STATE    │───S18
    └─────────────────────────────────────┘
                      │
                      ▼
    ┌─────────────────────────────────────┐
    │      MEASURE RESISTANCE VALUE       │───S20
    └─────────────────────────────────────┘
                      │
                      ▼
    ┌─────────────────────────────────────┐
    │   SECOND RESISTANCE VALUE R_{B1}    │───S22
    │      ← MEASUREMENT VALUE            │
    └─────────────────────────────────────┘
                      │
                      ▼
    ┌─────────────────────────────────────┐
    │  CALCULATE RESISTANCE VALUE R_{B0} AT│───S24
    │    REFERENCE TEMPERATURE t₀         │
    └─────────────────────────────────────┘
                      │
                      ▼
    ┌─────────────────────────────────────┐
    │      ACQUIRE FIRST INFORMATION      │───S26
    └─────────────────────────────────────┘
                      │
                      ▼
                     (A)
```

$S16$: TEMPERATURE OF OBJECT ← PREDETERMINED TEMPERATURE $t_1$

$S22$: SECOND RESISTANCE VALUE $R_{B1}$ ← MEASUREMENT VALUE

$S24$: CALCULATE RESISTANCE VALUE $R_{B0}$ AT REFERENCE TEMPERATURE $t_0$

# FIG. 4

A

n＝5 ——— S30

FORM SECOND CONNECTION STATE ——— S32

MEASURE SECOND RESISTANCE VALUE $R_{B(n)-1}$ ——— S34

FORM FIRST CONNECTION STATE ——— S36

MEASURE FIRST RESISTANCE VALUE $R_{A(n)}$ ——— S38

FORM SECOND CONNECTION STATE ——— S40

MEASURE SECOND RESISTANCE VALUE $R_{B(n)-2}$ ——— S42

n ← n − 1 ——— S44

MEASUREMENT PERFORMED PREDETERMINED NUMBER OF TIMES? (n=2?) ——— S46

NO

YES

B

FIG. 5

B

CALCULATE AVERAGE VALUE OF SECOND RESISTANCE VALUES MEASURED BEFORE AND AFTER EACH FIRST RESISTANCE VALUE AND ESTIMATE CALCULATED AVERAGE VALUE AS SECOND RESISTANCE VALUE AT TIME OF MEASURING EACH FIRST RESISTANCE VALUE — S50

SET TEMPERATURE OF JOINT PORTION OBTAINED FROM EACH MEASURED SECOND RESISTANCE VALUE AS TEMPERATURE OF JOINT PORTION AT TIME OF MEASURING EACH FIRST RESISTANCE VALUE — S52

ACQUIRE SECOND INFORMATION BASED ON RELATION BETWEEN MEASURED SECOND RESISTANCE VALUE AND ACQUIRED TEMPERATURE OF JOINT PORTION — S54

ACQUIRE RESISTANCE TEMPERATURE COEFFICIENT $\alpha_A$ OF JOINT PORTION BASED ON SECOND INFORMATION — S56

OBTAIN CALCULATION FORMULA FOR OBTAINING REFERENCE RESISTANCE VALUE $R_{A0}$ BASED ON RESISTANCE TEMPERATURE COEFFICIENT $\alpha_A$ OF JOINT PORTION AND REFERENCE TEMPERATURE $t_0$ — S58

RETURN

FIG. 6

FIG. 7

EP 4 585 933 A1

FIG. 8

FIG. 9

MEASUREMENT PROCESSING

FORM SECOND CONNECTION STATE — SB10

MEASURE SECOND RESISTANCE VALUE $R_{B6-1}$ — SB12

FORM FIRST CONNECTION STATE — SB14

MEASURE FIRST RESISTANCE VALUE $R_{A6'}$ — SB16

FORM SECOND CONNECTION STATE — SB18

MEASURE SECOND RESISTANCE VALUE $R_{B6-2}$ — SB20

$$R_{B6} = (R_{B6-1} + R_{B6-2}) / 2$$ — SB22

ACQUIRE TEMPERATURE $t_6$ AT $R_{B6}$ BASED ON FIRST INFORMATION — SB24

CALCULATE REFERENCE RESISTANCE VALUE $R_{A0'}$ BASED ON CALCULATION FORMULA USING $t_6$ — SB26

OUTPUT REFERENCE RESISTANCE VALUE $R_{A0'}$ — SB28

RETURN

FIG.10

FIG. 11

FIG. 12

EP 4 585 933 A1

FIG. 13

EP 4 585 933 A1

## INTERNATIONAL SEARCH REPORT

| International application No. |
| --- |
| **PCT/JP2023/030718** |

**A.    CLASSIFICATION OF SUBJECT MATTER**

**G01R 27/02**(2006.01)i; **G01K 7/02**(2021.01)i; **G01N 27/04**(2006.01)i
FI:    G01R27/02 R; G01K7/02 Z; G01N27/04 Z

According to International Patent Classification (IPC) or to both national classification and IPC

**B.    FIELDS SEARCHED**

Minimum documentation searched (classification system followed by classification symbols)

G01R27/02; G01K7/02; G01N27/04

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| A | JP 2019-60769 A (TOYOTA IND CORP) 18 April 2019 (2019-04-18)<br>entire text, all drawings (in particular, fig. 8) | 1-13 |
| A | CN 114002506 A (SINOCHEM INTERNATIONAL CORPORATION) 01 February 2022 (2022-02-01)<br>entire text, all drawings | 1-13 |
| A | JP 60-501475 A (AMERICAN TELEPHONE AND TELEGRAPH COMPANY) 05 September 1985 (1985-09-05)<br>entire text, all drawings | 1-13 |
| A | CN 111487465 A (GUILIN UNIVERSITY OF ELECTRONIC TECHNOLOGY) 04 August 2020 (2020-08-04)<br>entire text, all drawings | 1-13 |

☐ Further documents are listed in the continuation of Box C.    ☑ See patent family annex.

| | |
| --- | --- |
| *    Special categories of cited documents:<br>"A"    document defining the general state of the art which is not considered to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
| --- | --- |
| **02 November 2023** | **21 November 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/030718**

| Patent document cited in search report | | | Publication date (day/month/year) | Patent family member(s) | | | Publication date (day/month/year) |
|---|---|---|---|---|---|---|---|
| JP | 2019-60769 | A | 18 April 2019 | (Family: none) | | | |
| CN | 114002506 | A | 01 February 2022 | (Family: none) | | | |
| JP | 60-501475 | A | 05 September 1985 | US | 4667149 | A | |
| | | | | entire text, all drawings | | | |
| | | | | WO | 1984/004818 | A1 | |
| | | | | EP | 0134908 | A1 | |
| | | | | CA | 1235749 | A | |
| CN | 111487465 | A | 04 August 2020 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5115981 A
- JP 2022144045 A
- JP 2023100106 A